# EUROPEAN PATENT APPLICATION

(11) **EP 4 645 682 A1**
(43) Date of publication of application: **05.11.2025**
(21) Application number: 23912049.6
(22) Date of filing: 25.12.2023
(51) Int. Cl.: H02S 10/40, H01L 31/043, H01L 31/0468, H02S 30/00, H10K 30/40, H10K 39/12

(54) **PHOTOVOLTAIC GENERATION SYSTEM AND POWER GENERATION SYSTEM CONTROL METHOD**

(30) Priority: 27.12.2022 JP 2022210954
(71) Applicant: Panasonic Intellectual Property Management Co., Ltd., Kadoma-shi, Osaka 571-0057 (JP)
(72) Inventor: NISHIHARA, Takashi, Kadoma-shi, Osaka 571-0057 (JP)
(74) Representative: Grünecker Patent- und Rechtsanwälte PartG mbB
(86) International application number: PCT/JP2023/046411
(87) International publication number: WO 2024/143269

(57) **Abstract**

A photovoltaic power generation system (100) includes a first structure (110) and a second structure (120). The first structure (110) includes a plurality of first photoelectric conversion bodies (111) aligned in a first direction (151) at a first spacing (111s) and each extending in a second direction (152) as a length direction of the first photoelectric conversion body (111). The second structure (120) includes a plurality of second photoelectric conversion bodies (121) that are aligned in the first direction (151) at a second spacing (121s) and each extending in the second direction (152) as the length direction of the second photoelectric conversion body (121). At least one selected from the group consisting of a first requirement and a second requirement is satisfied. The first requirement is that a dimension of each of the first photoelectric conversion bodies (111) in the first direction (151) is different from a dimension of each of the second photoelectric conversion bodies (121) in the first direction (151). The second requirement is that the first spacing (111s) between the first photoelectric conversion bodies (111) is different from the second spacing (121s) between the second photoelectric conversion bodies (121).

## Description

### TECHNICAL FIELD

The present invention relates to a photovoltaic power generation system and a control method for controlling a power generation system.

### BACKGROUND ART

Photovoltaic power generation is known as a power generation method. Photovoltaic power generation is performed using a photoelectric conversion body. Patent Literature 1 describes a photovoltaic power generation system where a photoelectric conversion body is used.

### CITATION LIST

### Patent Literature

Patent Literature 1: JP H4-360983 A
Patent Literature 2: WO2020/208854

### SUMMARY OF INVENTION

### Technical Problem

The present disclosure provides a technique suitable for securing electric power generated by a photovoltaic power generation system.

### Solution to Problem

The present disclosure provides a photovoltaic power generation system including a first structure and a second structure, wherein
the first structure includes a plurality of first photoelectric conversion bodies aligned in a first direction at a first spacing and each extending in a second direction as a length direction of the first photoelectric conversion body, the second direction being orthogonal to the first direction, and
the second structure includes a plurality of second photoelectric conversion bodies aligned in the first direction at a second spacing and each extending in the second direction as a length direction of the second photoelectric conversion body,
the photovoltaic power generation system satisfying at least one of the following requirements:
   (1) a first requirement that a dimension of each of the first photoelectric conversion bodies in the first direction is different from a dimension of each of the second photoelectric conversion bodies in the first direction, and
   (2) a second requirement that the first spacing between the first photoelectric conversion bodies is different from the second spacing between the second photoelectric conversion bodies.

### Advantageous Effects of Invention

The technique according to the present disclosure is suitable for securing electric power generated by a photovoltaic power generation system.

### BRIEF DESCRIPTION OF DRAWINGS

FIG. 1 is an explanatory diagram of a photovoltaic power generation system according to Embodiment 1.
FIG. 2A is a diagram of a photovoltaic power generation system according to Embodiment 1 viewed from an orthogonal direction.
FIG. 2B is a diagram of a photovoltaic power generation system according to Embodiment 1 viewed from the orthogonal direction.
FIG. 2C is a diagram of a photovoltaic power generation system according to Embodiment 1 viewed from an orthogonal direction.
FIG. 3 is a cross-sectional view of a photovoltaic power generation system according to Embodiment 1.
FIG. 4 is an explanatory diagram of an arrangement of a plurality of first photoelectric conversion bodies.
FIG. 5 is an explanatory diagram of an electrical connection of a plurality of first photoelectric conversion bodies.
FIG. 6 is an explanatory diagram of an arrangement of a plurality of second photoelectric conversion bodies.
FIG. 7 is an explanatory diagram of an electrical connection of a plurality of second photoelectric conversion bodies.
FIG. 8A is a plan view of a first configuration example where an integrated solar cell module is used.
FIG. 8B is a cross-sectional view of the first configuration example where an integrated solar cell module is used.
FIG. 9A is a plan view of a second configuration example where an integrated solar cell module is used.
FIG. 9B is a cross-sectional view of the second configuration example where an integrated solar cell module is used.
FIG. 10A is an explanatory diagram of peak values and bottom values.
FIG. 10B is an explanatory diagram of peak values and bottom values.
FIG. 11 is an explanatory diagram of an electrical system and a control system of a photovoltaic power generation system according to Embodiment 1.
FIG. 12 is an explanatory diagram of the photovoltaic power generation system according to Embodiment 2.
FIG. 13 is an explanatory diagram of a first latch.
FIG. 14A is a diagram of a first main body viewed from a longitudinal direction.
FIG. 14B is a diagram of the first main body viewed from an orthogonal direction.
FIG. 14C is a diagram of the first main body viewed from a transverse direction.
FIG. 14D is a diagram of a first main body viewed from a longitudinal direction.
FIG. 15A is a diagram of a first strike plate viewed from a longitudinal direction.
FIG. 15B is a diagram of a first strike plate viewed from an orthogonal direction.
FIG. 15C is a diagram of a first strike plate viewed from a transverse direction.
FIG. 16 is an explanatory diagram of a photovoltaic power generation system according to a first reference example.
FIG. 17A is a diagram of the photovoltaic power generation system viewed from an orthogonal direction.
FIG. 17B is a diagram of the photovoltaic power generation system viewed from an orthogonal direction.

### DESCRIPTION OF EMBODIMENTS

Hereinafter, the present disclosure will be explained based on embodiments, with reference to the attached drawings, though the present disclosure is not limited to the following embodiments. The drawings are schematic diagrams.

### (Embodiment 1)

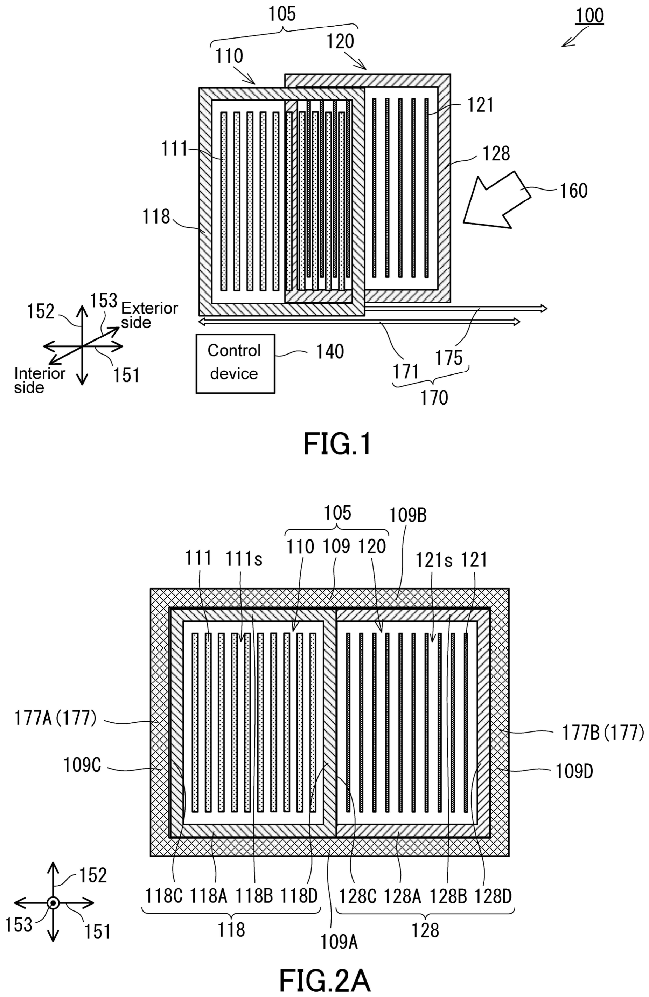

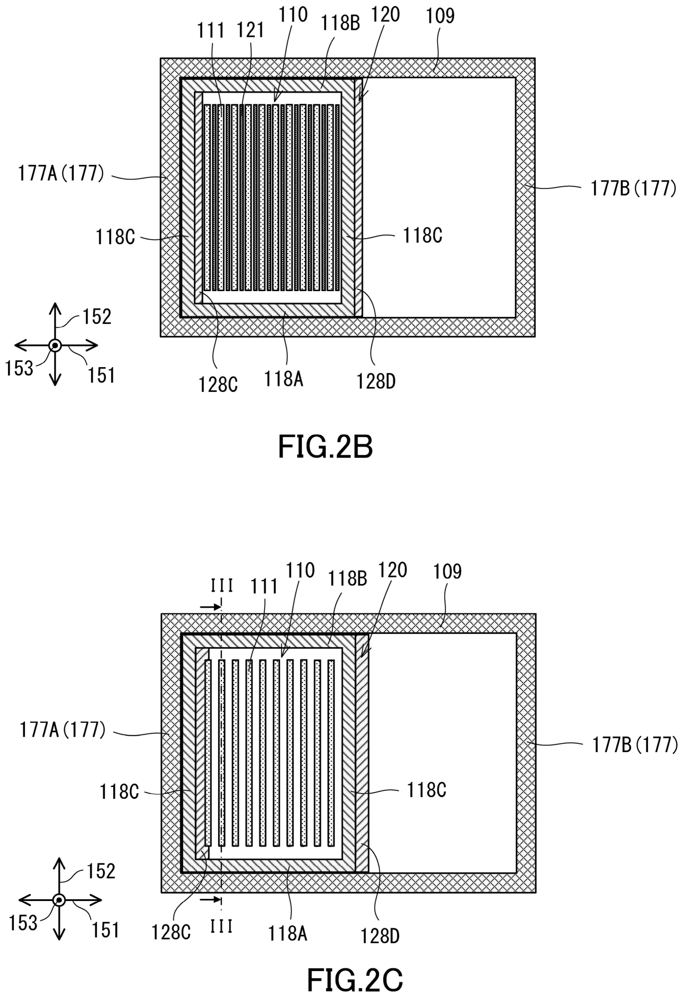

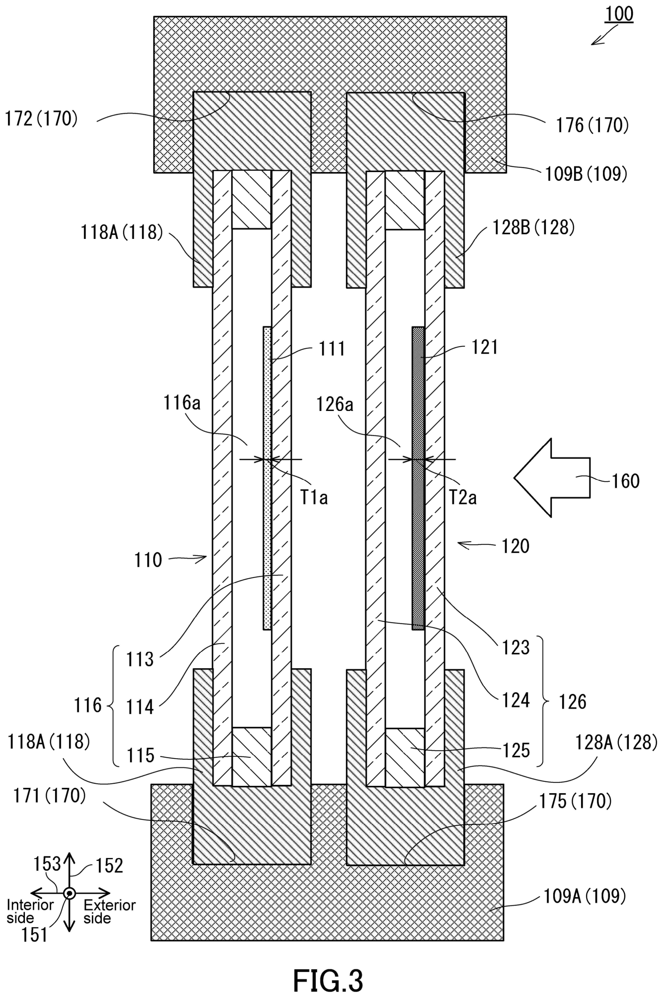

FIG. 1 is an explanatory diagram of a photovoltaic power generation system 100 according to Embodiment 1. FIG. 2A, FIG. 2B and FIG. 2C are diagrams of the photovoltaic power generation system 100 according to Embodiment 1, viewed from an orthogonal direction 153. FIG. 3 is a cross-sectional view of the photovoltaic power generation system 100 according to Embodiment 1. The photovoltaic power generation system 100 includes a window unit 105. Specifically, in FIG. 2A, the window unit 105 is closed. In FIG. 2B and FIG. 2C, the window unit 105 is open. FIG. 3 is a cross-sectional view of the photovoltaic power generation system 100 shown in FIG. 2C, taken along a line III-III and viewed in a direction indicated with a pair of arrows.

The photovoltaic power generation system 100 includes an interior window (first structure) 110, an exterior window (second structure) 120, and a window frame 109. The interior window 110 is disposed closer to the interior side than the exterior window 120. In other words, the exterior window 120 is disposed closer to the exterior side than the interior window 110. The window frame 109 guides a move of at least one selected from the group consisting of the interior window 110 and the exterior window 120. A window unit 105 includes the interior window 110, the exterior window 120, and the window frame 109. A sliding window is configured for the window unit 105 of the present embodiment. An arrow 160 indicates a direction of light (specifically, sunlight) incidence. In the present Description, the term "window" refers to a member to be installed in an opening. The "window" may be a fitting. The "window" may be shaped as a board. The "window" may be light-transmissive. The "window" may be movable or immovable. The "window" may include, for example, glass, resin, or the like.

In FIG. 1 to FIG. 3, a transverse direction (first direction) 151, a longitudinal direction (second direction) 152, and an orthogonal direction (third direction) 153 are shown. The transverse direction 151, the longitudinal direction 152, and the orthogonal direction 153 are mutually orthogonal directions. In Embodiment 1, the transverse direction 151 is the direction for opening/closing the window unit 105. The window unit 105 is opened and closed by moving at least one selected from the group consisting of the interior window 110 and the exterior window 120 in the transverse direction 151. The orthogonal direction 153 is a direction from the exterior to the interior or from the interior to the exterior.

In the present Description, "orthogonal" does not necessarily mean that the formed angle is exactly 90°. In the present Description, an angle of 85° or more and 95° or less is regarded as "orthogonal".

The terms "transverse direction (first direction) 151", "longitudinal direction (second direction) 152" and "orthogonal direction (third direction) 153" simply express a relative relationship. The transverse direction (first direction) 151 may be the horizontal direction or the vertical direction. The longitudinal direction (second direction) 152 may be the vertical direction or the horizontal direction. Here, the vertical direction is the direction of gravity.

In Embodiment 1, the second structure 120 is disposed closer to the light (specifically, sunlight) incident side than the first structure 110. The first structure 110 is disposed closer to the interior side than the second structure 120, and the second structure 120 is disposed closer to the exterior side than the first structure 110. The first structure 110 and the second structure 120 are disposed at positions different from each other with respect to the orthogonal direction 153.

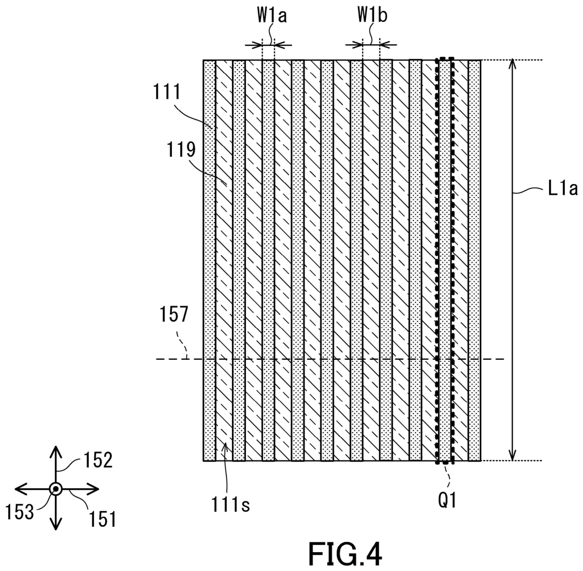

FIG. 4 is an explanatory diagram of an arrangement of a plurality of first photoelectric conversion bodies 111. The first photoelectric conversion bodies 111 each extend in the longitudinal direction 152 as the length direction of the first photoelectric conversion body 111. The first photoelectric conversion bodies 111 are aligned in the transverse direction 151 at a first spacing 111s. Among the first photoelectric conversion bodies 111, two adjacent first photoelectric conversion bodies 111 each have regions that face each other with respect to the transverse direction 151. In the present embodiment, when viewed from the orthogonal direction 153, the first photoelectric conversion bodies 111 are disposed such that a first virtual straight line 157 extending in the transverse direction 151 intersects with the first photoelectric conversion bodies 111. The number of the first photoelectric conversion bodies 111 is, for example, 2 or more and 50 or less, or may be 10 or more and 30 or less. The first photoelectric conversion bodies 111 each are configured using, for example, part or all of an integrated solar cell module. An integrated solar cell module is an assembly that includes a plurality of elements for performing photovoltaic power generation. The elements include, for example, a plurality of photoelectric conversion elements. The light-absorbing layer 23 may correspond to the photoelectric conversion element in this context. Here, "when viewed from the orthogonal direction 153" means "when viewed through an orthogonal direction 153".

The following description refers to the expression that the first photoelectric conversion body 111 extends in the longitudinal direction 152 as the length direction of the first photoelectric conversion body 111. A rectangle defined as a first evaluation rectangle Q1 is the smallest rectangle that can accommodate the first photoelectric conversion body 111 when viewed from the orthogonal direction 153, as shown in FIG. 4, and it is a rectangle having sides extending in the transverse direction 151 and sides extending in the longitudinal direction 152. In the above expression, that is, "the first photoelectric conversion body 111 extends in the longitudinal direction 152 as the length direction of the first photoelectric conversion body 111", the term "length direction" refers to the long side direction of the first evaluation rectangle Q1. In the above expression, "extend" refers to "extend continuously or intermittently". The first photoelectric conversion body 111 may be rounded, and even in such a case, the above explanation is still valid.

The following description refers to the expression that "the first photoelectric conversion body 111 extend intermittently in the longitudinal direction 152 as the length direction of the first photoelectric conversion body 111". This expression encompasses the following:
- a plurality of photoelectric conversion elements are electrically connected in series via one or a plurality of electrodes, and aligned in the longitudinal direction 152. The first electrode 26 and/or the second electrode 21 can correspond to the electrodes in this context. The light-absorbing layer 23 can correspond to the photoelectric conversion element in this context. In this context, "electrically connected" can specifically mean "electrically connected in series".

Each of the first spacings 111s has a first light-transmissive region 119. The first light-transmissive region 119 extends in the longitudinal direction 152 as the length direction of the first light-transmissive region 119. Here, "each of the first spacings 111s" includes both cases where there is one first spacing 111s and where there are a plurality of first spacings 111s.

In the present embodiment, each of the first photoelectric conversion bodies 111 is aligned in the transverse direction 151 via the first light-transmissive region 119. In the example shown in FIG. 4, the number of first photoelectric conversion bodies 111 is 10, and the number of the first light-transmissive regions 119 is 9. The first photoelectric conversion bodies 111 and the first light-transmissive regions 119 are aligned alternately in the transverse direction 151. More typically, in the present embodiment, the number of the first photoelectric conversion bodies 111 is m (where m is a positive integer greater than or equal to 2), and the number of first light-transmissive regions 119 is (m-1).

Here, an average value of the light transmittance in the wavelength range of 400 nm or more and 800 nm or less is defined as a specific light transmittance. In this case, the specific light transmittance of the first light-transmissive region 119 in the orthogonal direction 153 is higher than the specific light transmittance of the first photoelectric conversion body 111 in the orthogonal direction 153.

In FIG. 4, a dimension W1a is a dimension of a first photoelectric conversion body 111 in the transverse direction 151. A dimension W1b is a dimension of the first light-transmissive region 119 in the transverse direction 151. For example, the dimension W1a is 50% or more and 130% or less of the dimension W1b. The dimension W1a may be 70% or more and 120% or less of the dimension W1b. The first light-transmissive region 119 may be a space or a light-transmissive object.

In FIG. 4, a dimension L1a is a dimension of the first photoelectric conversion body 111 in the longitudinal direction 152. A dimension W1a is a dimension of the first photoelectric conversion body 111 in the transverse direction 151. A ratio L1a/W1a of the dimension L1a to the dimension W1a is, for example, 2 or more and 480 or less. The ratio L1a/W1a may be 5 or more and 40 or less.

The dimension W1a is, for example, 5 mm or more and 100 mm or less. The dimension W1a may be 10 mm or more and 50 mm or less. The dimension W1b is, for example, 3 mm or more and 100 mm or less. The dimension W1b may be 8 mm or more and 50 mm or less. The dimension L1a is, for example, 200 mm or more and 2400 mm or less. The dimension L1a may be 500 mm or more and 1800 mm or less.

In FIG. 3, a dimension T1a is a dimension of the first photoelectric conversion body 111 in the orthogonal direction 153. Specifically, the dimension T1a is a thickness of the first photoelectric conversion body 111. The dimension T1a is, for example, 100 nm or more and 100 µm or less. The lower limit of the range of the dimension T1a may be 200 nm, or may be 500 nm. The upper limit of the range of the dimension T1a may be 10 µm, may be 5 µm, may be 1.5 µm, or may be 1.2 µm.

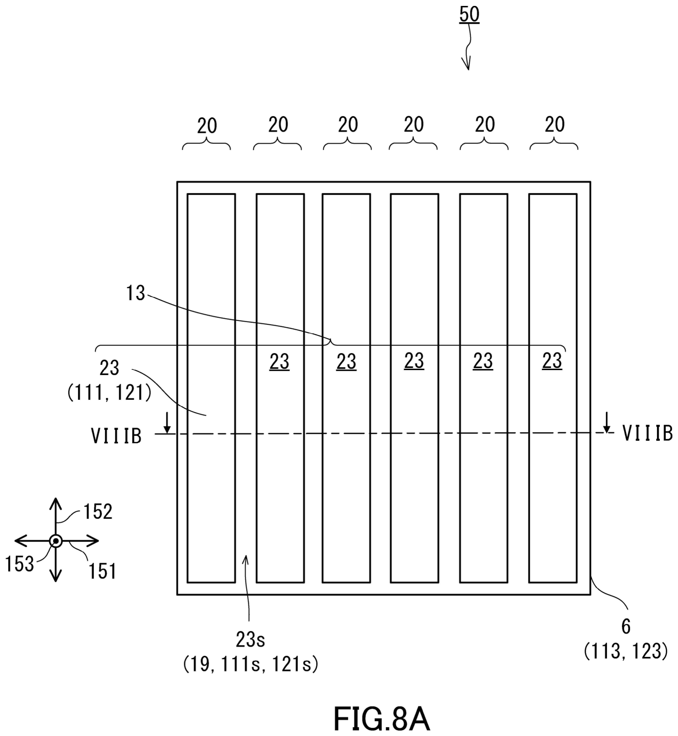

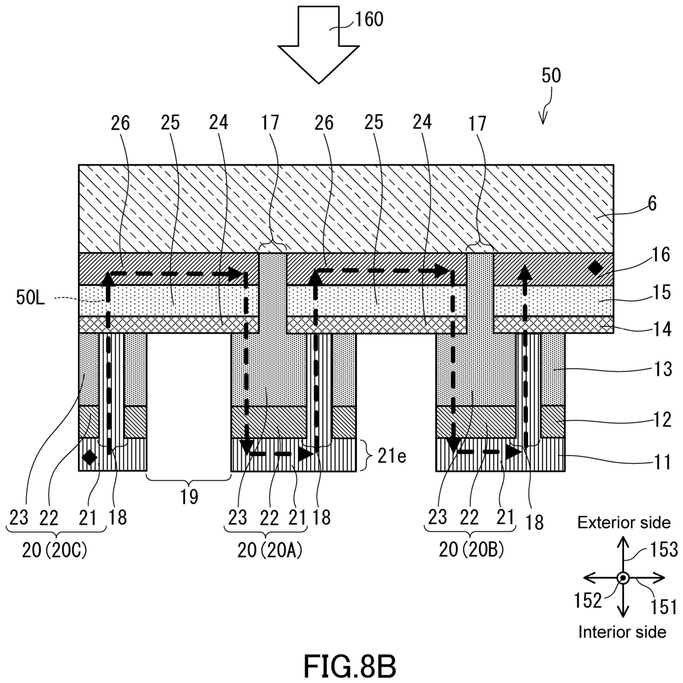

The first photoelectric conversion bodies 111 are electrically connected in series. The electrical connection is not limited to any particular aspect. In the present embodiment, when viewed from the orthogonal direction 153, the first photoelectric conversion bodies 111 are electrically connected to each other along the transverse direction 151. A specific example of the configuration will be explained later, with reference to FIG. 8A and FIG. 8B. Over the entire dimension L1a in the longitudinal direction 152, each of the first photoelectric conversion bodies 111 may be electrically connected to another first photoelectric conversion body 111 adjacent with respect to the transverse direction 151.

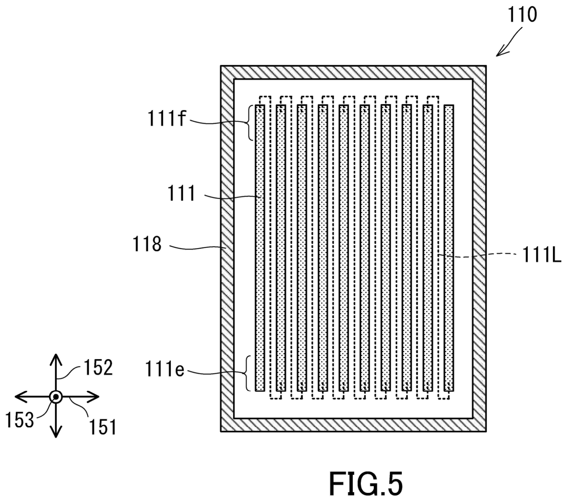

FIG. 5 is an explanatory diagram of a variation of the electrical connection of the first photoelectric conversion bodies 111. In FIG. 5, the electrical connection is shown schematically with a dotted line 111L. The first photoelectric conversion bodies 111 are electrically connected in series. Specifically, each of the first photoelectric conversion bodies 111 includes an end portion 111e and an end portion 111f facing each other in the longitudinal direction 152. Each of the end portion 111e and the end portion 111f is, for example, a region of the first photoelectric conversion body 111 equally divided into ten divisions in the longitudinal direction 152. In FIG. 5, as for the first photoelectric conversion bodies 111, the end portion 111e of one of two adjacent first photoelectric conversion bodies 111 is electrically connected to the end portion 111f of the other first photoelectric conversion body 111.

As shown in FIG. 2A, the interior window 110 includes a first support frame 118. The first support frame 118 supports the first photoelectric conversion bodies 111. When viewed from the orthogonal direction 153, the first support frame 118 has a closed frame shape. In the present embodiment, both an inner contour and an outer contour of the closed frame have a shape of rectangle. Here, the term "rectangle" indicates a concept including a square. When viewed from the orthogonal direction 153, the entire first photoelectric conversion body 111 is located within this closed frame. The first support frame 118 is made of metal or resin, for example. In the present embodiment, the first support frame 118 supports the first photoelectric conversion bodies 111 via the first substrate 113.

The following description refers to the expression "the first support frame 118 supports a plurality of first photoelectric conversion bodies 111". This expression encompasses a form in which the first support frame 118 supports the first photoelectric conversion bodies 111 by contacting with the first photoelectric conversion bodies 111. This expression encompasses also a form in which the first support frame 118 supports the first photoelectric conversion bodies 111 via another member. This holds true also for expressions such as "the second support frame 128 supports a plurality of second photoelectric conversion bodies 121", "the first photoelectric conversion bodies 111 ... are supported by the first substrate 113", and "a plurality of second photoelectric conversion bodies 121 ... are supported by the third substrate 123". In the present embodiment, as shown in FIG. 3, the first support frame 118 supports the first photoelectric conversion bodies 111 via the first substrate 113.

As shown in FIG. 2A, the first support frame 118 includes a first frame member 118A, a second frame member 118B, a third frame member 118C, and a fourth frame member 118D. The first frame member 118A and the second frame member 118B extend in the transverse direction 151. The first frame member 118A and the second frame member 118B face each other. The third frame member 118C connects the first frame member 118A and the second frame member 118B. The fourth frame member 118D connects the first frame member 118A and the second frame member 118B. The third frame member 118C and the fourth frame member 118D face each other. When viewed from the orthogonal direction 153, the first frame member 118A, the second frame member 118B, the third frame member 118C and the fourth frame member 118D are combined to shape the closed frame shape as described above. The third frame member 118C and the fourth frame member 118D extend in a direction different from the transverse direction 151, specifically these frame members extend in the longitudinal direction 152.

As shown in FIG. 3, the interior window 110 includes a first substrate 113, a second substrate 114, and a spacer 115. The first substrate 113 is provided to the exterior side. The second substrate 114 is provided to the interior side. In the present embodiment, the first substrate 113 and the second substrate 114 are made of glass. In other words, the first substrate 113 and the second substrate 114 are glass panes. The first spacer 115 has a closed frame shape when viewed from the orthogonal direction 153. A first double glazing 116 is configured to include the first substrate 113, the second substrate 114, and the first spacer 115. A void layer 116a is provided inside the first double glazing 116 partitioned by the first substrate 113, the second substrate 114, and the first spacer 115. The void layer 116a is, for example, an air layer. Alternatively, it may be, for example, an argon layer or for example, a layer with a higher degree of vacuum than the outside air. The first photoelectric conversion bodies 111 are disposed inside the void layer 116a and supported by the first substrate 113. The first substrate 113 protects the first photoelectric conversion bodies 111. A specific light transmittance of the first substrate 113 in the orthogonal direction 153 is, for example, 80% or more and less than 100%. A specific light transmittance of the second substrate 114 in the orthogonal direction 153 is, for example, 80% or more and less than 100%. The first substrate 113 and the second substrate 114 may be made of resin.

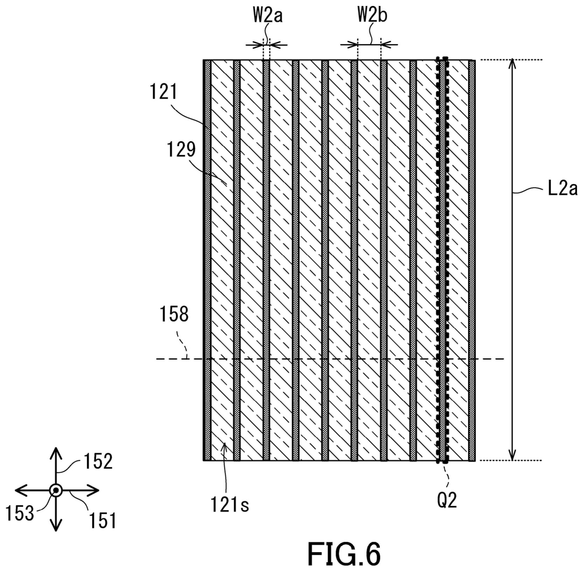

FIG. 6 is an explanatory diagram of an arrangement of the second photoelectric conversion bodies 121. The second photoelectric conversion bodies 121 each extend in the longitudinal direction 152 as a length direction of the second photoelectric conversion body 121. The second photoelectric conversion bodies 121 are aligned in the transverse direction 151 at a second spacing 121s. Among the second photoelectric conversion bodies 121, two adjacent second photoelectric conversion bodies 121 each have regions that face each other with respect to the transverse direction 151. In the present embodiment, the second photoelectric conversion bodies 121 are disposed such that the second virtual straight line 158 extending in the transverse direction 151 intersects with the second photoelectric conversion bodies 121 when viewed from the orthogonal direction 153. The number of second photoelectric conversion bodies 121 is, for example, 2 or more and 50 or less, and may be 10 or more and 30 or less. Each of the second photoelectric conversion bodies 121 is, for example, configured using part or all of the integrated solar cell module.

The following description refers to the expression that the second photoelectric conversion body 121 extends in the transverse direction 151 as the length direction of the second photoelectric conversion body 121. A rectangle defined as a second evaluation rectangle Q2 is the smallest rectangle that can accommodate the second photoelectric conversion body 121 when viewed from the orthogonal direction 153, as shown in FIG. 6, and it is a rectangle having sides extending in the transverse direction 151 and sides extending in the longitudinal direction 152. In the above expression, that is, in "the second photoelectric conversion body 121 extends in the longitudinal direction 152 as the length direction of the second photoelectric conversion body 121", the term "length direction" refers to the long side direction of the second evaluation rectangle Q2. In the above expression, "extend" refers to "extend continuously or intermittently". The second photoelectric conversion body 121 may be rounded, and in even that case, the explanation is still valid.

The following description relates to the expression that "the second photoelectric conversion body 121 extends intermittently in the longitudinal direction 152 as the length direction of the second photoelectric conversion body 121". This expression encompasses the following:
- a plurality of photoelectric conversion elements are electrically connected via one or a plurality of electrodes and aligned in the longitudinal direction 152. The first electrode 26 and/or the second electrode 21 can correspond to the electrodes in this context. The light-absorbing layer 23 can correspond to the photoelectric conversion element in this context. In this context, "electrically connected" can specifically mean "electrically connected in series".

In each of the second spacings 121s, a second light-transmissive region 129 is provided. The second light-transmissive region 129 extends in the longitudinal direction 152 as the length direction. Here, "each of the second spacings 121s" encompasses the case where there is one second spacing 121s and the case where there are a plurality of second spacings 121s.

In the present embodiment, each of the second photoelectric conversion bodies 121 is aligned in the transverse direction 151 via the second light-transmissive region 129. In the example shown in FIG. 6, the number of second photoelectric conversion bodies 121 is 10, and the number of second light-transmissive regions 129 is 9. The second photoelectric conversion bodies 121 and the second light-transmissive regions 129 are aligned alternately in the transverse direction 151. More typically, in the present embodiment, the number of the second photoelectric conversion bodies 121 is n (where n is a positive integer greater than or equal to 2), and the number of the second light-transmissive regions 129 is (n-1). The number n of the second photoelectric conversion bodies 121 may be the same as or may be different from the number m of first photoelectric conversion bodies 111.

The specific light transmittance of the second light-transmissive region 129 in the orthogonal direction 153 is higher than the specific light transmittance of the second photoelectric conversion body 121 in the orthogonal direction 153.

In FIG. 6, a dimension W2a is a dimension of the second photoelectric conversion body 121 in the transverse direction 151. A dimension W2b is a dimension of the second light-transmissive region 129 in the transverse direction 151. For example, the dimension W2a is 40% or more and 120% or less of the dimension W2b. The dimension W2a may be 60% or more and 110% or less of the dimension W2b. The second light-transmissive region 129 may be a space or a light-transmissive object.

In FIG. 6, a dimension L2a is a dimension of the second photoelectric conversion body 121 in the longitudinal direction 152. A dimension W2a is a dimension of the second photoelectric conversion body 121 in the transverse direction 151. A ratio L2a/W2a of the dimension L2a to the dimension W2a is, for example, 2 or more and 600 or less. The ratio L2a/W2a may be 5 or more and 40 or less.

The dimension W2a is, for example, 4 mm or more and 100 mm or less. The dimension W2a may be 8 mm or more and 40 mm or less. The dimension W2b is, for example, 5 mm or more and 120 mm or less. The dimension W2b may be 10 mm or more and 60 mm or less. The dimension L2a is, for example, 200 mm or more and 2400 mm or less. The dimension L2a may be 500 mm or more and 1800 mm or less.

In FIG. 3, a dimension T2a is a dimension of the second photoelectric conversion body 121 in the orthogonal direction 153. Specifically, the dimension T2a is a thickness of the second photoelectric conversion body 121. The dimension T2a is, for example, 200 nm or more and 110 µm or less. The lower limit of the range of the dimension T2a may be 300 nm, or may be 600 nm. The upper limit of the range of the dimension T2a may be 11 µm, may be 6 µm, may be 1.6 µm, or may be 1.3 µm.

The second photoelectric conversion bodies 121 are electrically connected in series. The aspect of the electrical connection is not particularly limited. In the present embodiment, when viewed from the orthogonal direction 153, the second photoelectric conversion bodies 121 are electrically connected to each other along the transverse direction 151. A specific example of this configuration will be explained later, with reference to FIG. 8A and FIG. 8B. Over the entire dimension L2a in the longitudinal direction 152, each of the second photoelectric conversion bodies 121 may be electrically connected to an adjacent second photoelectric conversion body 121 with respect to the transverse direction 151.

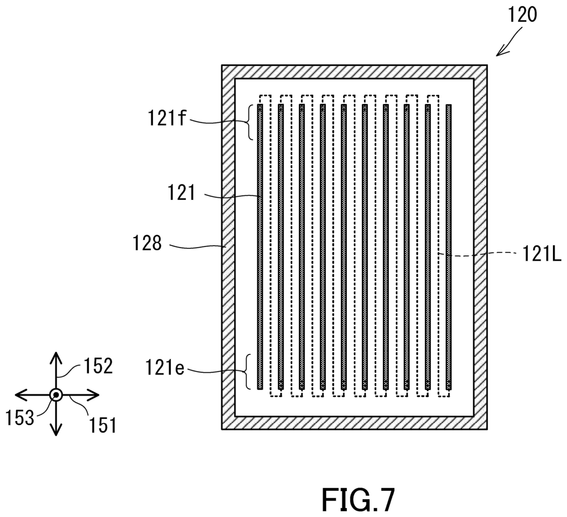

FIG. 7 is an explanatory diagram of a variation of the electrical connection of the second photoelectric conversion bodies 121. In FIG. 7, the electrical connection is shown schematically with a dotted line 121L. The second photoelectric conversion bodies 121 are electrically connected in series. Specifically, each of the second photoelectric conversion bodies 121 includes an end portion 121e and an end portion 121f facing each other in the longitudinal direction 152. Each of the end portion 121e and the end portion 121f is, for example, a region of the second photoelectric conversion body 121 equally divided into ten divisions in the longitudinal direction 152. As for the second photoelectric conversion bodies 121, the end portion 121e of one of two adjacent second photoelectric conversion bodies 121 is electrically connected to the end portion 121f of the other second photoelectric conversion body 121.

Here, a serially-connected body of the first photoelectric conversion bodies 111 is defined as a first serially-connected body. A serially-connected body of the second photoelectric conversion bodies 121 is defined as a second serially-connected body. In the present embodiment, the first serially-connected body and the second serially-connected body are electrically connected to each other. The first serially-connected body and the second serially-connected body may be electrically connected in series or in parallel. The first serially-connected body and the second serially-connected body may not be electrically connected to each other.

As shown in FIG. 2A, the exterior window 120 includes a second support frame 128. The second support frame 128 supports a plurality of second photoelectric conversion bodies 121. When viewed from the orthogonal direction 153, the second support frame 128 has a closed frame shape. In the present embodiment, an inner contour and an outer contour of this closed frame shape are rectangles. When viewed from the orthogonal direction 153, the entire second photoelectric conversion body 121 is located within this closed frame. The second support frame 128 is made of metal or resin, for example. In the present embodiment, the second support frame 128 supports the second photoelectric conversion bodies 121 via the third substrate 123.

As shown in FIG. 2A, the second support frame 128 includes a fifth frame member 128A, a sixth frame member 128B, a seventh frame member 128C, and an eighth frame member 128D. The fifth frame member 128A and the sixth frame member 128B extend in the transverse direction 151. The fifth frame member 128A and the sixth frame member 128B face each other. The seventh frame member 128C connects the fifth frame member 128A and the sixth frame member 128B. The eighth frame member 128D connects the fifth frame member 128A and the sixth frame member 128B. The seventh frame member 128C and the eighth frame member 128D face each other. When viewed from the orthogonal direction 153, the fifth frame member 128A, the sixth frame member 128B, the seventh frame member 128C and the eighth frame member 128D are combined to shape the closed frame as described above. The seventh frame member 128C and the eighth frame member 128D extend in a direction different from the transverse direction 151, specifically the frame members extend in the longitudinal direction 152.

As shown in FIG. 3, the exterior window 120 includes a third substrate 123, a fourth substrate 124, and a second spacer 125. The third substrate 123 is provided to the exterior side. The fourth substrate 124 is provided to the interior side. In the present embodiment, the third substrate 123 and the fourth substrate 124 are made of glass. In other words, the third substrate 123 and the fourth substrate 124 are glass panes. The second spacer 125 has a closed frame shape when viewed from the orthogonal direction 153. A second double glazing 126 is configured to include the third substrate 123, the fourth substrate 124, and the second spacer 125. A void layer 126a is provided inside the second double glazing 126 partitioned by the third substrate 123, the fourth substrate 124, and the second spacer 125. The void layer 126a is, for example, an air layer. Alternatively, it may be, for example, an argon layer or for example, a layer with a higher degree of vacuum than the outside air. The second photoelectric conversion bodies 121 are disposed inside the void layer 126a and supported by the third substrate 123. The third substrate 123 protects the second photoelectric conversion bodies 121. A specific light transmittance of the third substrate 123 in the orthogonal direction 153 is, for example, 80% or more and less than 100%. A specific light transmittance of the fourth substrate 124 in the orthogonal direction 153 is, for example, 80% or more and less than 100%. The third substrate 123 and the fourth substrate 124 may be made of resin.

A guide 170 is provided on the window frame 109. The guide 170 guides a relative move in which the exterior window 120 moves in the transverse direction 151 with respect to the interior window 110. In the relative move, of the interior window 110 and the exterior window 120, either only the interior window 110 or only the exterior window 120 may move. Alternatively, in the relative move, both the interior window 110 and the exterior window 120 may move.

Specifically in the present embodiment, the guide 170 includes the first frame member 109A and the second frame member 109B of the window frame 109. The first frame member 109A and the second frame member 109B face each other and extend in the transverse direction 151.

In the present embodiment, the guide 170 allows at least one of the interior window 110 and the exterior window 120 to move in the transverse direction 151, while engaging with at least one of the interior window 110 and the exterior window 120. Specifically, the guide 170 allows at least one of the interior window 110 and the exterior window 120 to slide in the transverse direction 151 while the guide 170 mutually fitting with at least one of the interior window 110 and the exterior window 120.

Specifically, as shown in FIG. 3, the guide 170 has a first groove 171 and a second groove 172. The first groove 171 and the second groove 172 extend in the transverse direction 151 so as to clamp the interior window 110 from the longitudinal direction 152. The first groove 171 and the second groove 172 may allow the interior window 110 to slide in the transverse direction 151. More specifically, the first groove 171 and the second groove 172 allow the first support frame 118 to slide in the transverse direction 151.

The guide 170 further has a third groove 175 and a fourth groove 176. The third groove 175 and the fourth groove 176 extend in the transverse direction 151 so as to clamp the exterior window 120 from the longitudinal direction 152. The third groove 175 and the fourth groove 176 allow the exterior window 120 to slide in the transverse direction 151. More specifically, the third groove 175 and the fourth groove 176 allow the second support frame 128 to slide in the transverse direction 151.

In the present embodiment, the relative move achieves a state in which at least one of the first photoelectric conversion bodies 111 overlaps with the seventh frame member 128C when viewed from the orthogonal direction 153. Specifically, the relative move achieves a state in which the seventh frame member 128C and the first photoelectric conversion bodies 111 overlap with each other when viewed from the orthogonal direction 153. In the present embodiment, the relative move achieves a state in which at least one of the first photoelectric conversion bodies 111 overlaps with the eighth frame member 128D when viewed from the orthogonal direction 153. Specifically, the relative move achieves a state in which the eighth frame member 128D and the first photoelectric conversion bodies 111 overlap with each other when viewed from the orthogonal direction 153. When viewed from the orthogonal direction 153, the fifth frame member 128A and the first photoelectric conversion bodies 111 do not overlap with each other. The relative move achieves a state in which the fifth frame member 128A and the first frame member 118A overlap with each other when viewed from the orthogonal direction 153. When viewed from the orthogonal direction 153, the sixth frame member 128B and the first photoelectric conversion bodies 111 do not overlap with each other. The relative move achieves a state in which the sixth frame member 128B and the second frame member 118B overlap with each other when viewed from the orthogonal direction 153.

As can be understood from FIG. 2A to FIG. 2C, the range of relative move by the guide 170 is limited to the first range by a stopper 177. More specifically, the stopper 177 includes a first wall 177A and a second wall 177B. The first wall 177A defines one end of each of a first groove 171, a second groove 172, a third groove 175, and a fourth groove 176 with respect to the transverse direction 151, as shown in FIG. 3. The second wall 177B defines the other end of each of the first groove 171, the second groove 172, the third groove 175 and the fourth groove 176 with respect to the transverse direction 151. Since the interior window 110 and the exterior window 120 get contact with the first wall 177A, the interior window 110 and the exterior window 120 are prevented from moving in the transverse direction 151. Since the interior window 110 and the exterior window 120 get contact with the second wall 177B, the interior window 110 and the exterior window 120 are prevented from moving in the transverse direction 151. The term "get contact" means that "touch to be in contact". In the examples shown in FIG. 2A to FIG. 2C, the first wall 177A is the third frame member 109C of the window frame 109. The second wall 177B is the fourth frame member 109D of the window frame 109. The third frame member 109C and the fourth frame member 109D face each other. The third frame member 109C and the fourth frame member 109D extend in a direction different from the transverse direction 151, specifically the frame members extend in the vertical direction 152.

The first photoelectric conversion body 111 converts light into electric charge. Specifically, the first photoelectric conversion body 111 includes a material capable of converting light into electric charge. The first photoelectric conversion body 111 may include a perovskite compound. The first photoelectric conversion body 111 may include silicon. In the present embodiment, the first photoelectric conversion body 111 is in the form of a film, specifically a thin-film type photoelectric conversion body. A thin-film type photoelectric conversion body refers to a photoelectric conversion body with a thickness of 100 nm or more and 10 µm or less. Specifically, the lower limit of the thickness range of the thin-film type photoelectric conversion body may be 500 nm. The upper limit of the thickness range of the thin-film type photoelectric conversion body may be 1.5 µm.

A second photoelectric conversion body 121 converts light into electric charge. Specifically, the second photoelectric conversion body 121 includes a material capable of converting light into electric charge. The second photoelectric conversion body 121 may include a perovskite compound. The second photoelectric conversion body 121 may include silicon. In the present embodiment, the second photoelectric conversion body 121 is in the form of a film, specifically a thin-film type photoelectric conversion body.

The first photoelectric conversion body 111 may be configured using a part or all of the integrated solar cell module. FIG. 8A is a plan view of a first configuration example in which an integrated solar cell module 50 is used. FIG. 8B is a cross-sectional view of the first configuration example in which the integrated solar cell module 50 is used. Specifically, FIG. 8B is a cross-sectional view of the integrated solar cell module 50 shown in FIG. 8A, taken along a line VIIIB-VIIIB and viewed in a direction indicated with a pair of arrows. In FIG. 8A, elements other than the light-absorbing layer 23 in the unit cell 20 are not shown. In FIG. 8B, some of the components of the integrated solar cell module 50 are not shown.

As shown in FIG. 8A, in the integrated solar cell module 50, the light-absorbing layers 23 each extend in the longitudinal direction 152 as the length direction. A plurality of light-absorbing layers 23 are aligned at a spacing 23s in the transverse direction 151.

The integrated solar cell module 50 includes a light-transmissive substrate 6 and a plurality of unit cells 20. Among the unit cells 20, unit cells 20 adjacent to each other are electrically connected in series.

As shown in FIG. 8B, the integrated solar cell module 50 includes a light-transmissive substrate 6, a first electrode 16, an electron transport layer 15, a porous layer 14, a light-absorbing layer 13, a hole transport layer 12, and a second electrode 11, these components being stacked in this order. The light-absorbing layer 13 includes a perovskite compound represented by a formula AMX₃, for example. Here, A is a monovalent cation, M is a divalent cation, and X is a monovalent anion.

The first electrode 16, the electron transport layer 15, and the porous layer 14 are divided by first dividing grooves 17 into a plurality of first electrodes 26, a plurality of electron transport layers 25, and a plurality of porous layers 24, respectively. The light-absorbing layer 13 and the hole transport layer 12 are divided by second dividing grooves 18 into a plurality of light-absorbing layers 23 and a plurality of hole transport layers 22, respectively. The second electrode 11 is divided by third dividing grooves 19 into a plurality of second electrodes 21. In the first configuration example, the third dividing grooves 19 are also formed in the light-absorbing layer 13 and the hole transport layer 12. The first dividing grooves 17, the second dividing grooves 18, and the third dividing grooves 19 extend like stripes in the longitudinal direction 152.

In the first configuration example, part of the light-absorbing layer 23 extends into the first dividing groove 17. Part of the second electrode 21 extends into the second dividing groove 18. A space is formed in the interior of the third dividing groove 19.

Each of the unit cells 20 has a layered structure in which the first electrode 26, the electron transport layer 25, the porous layer 24, the light-absorbing layer 23, the hole transport layer 22, and the second electrode 21 are stacked in this order. Each second dividing groove 18 is disposed so as to overlap with the first electrode 26, the electron transport layer 25, and the porous layer 24 when viewed from the direction 153. In a second dividing groove 18, the second electrode 21 of an adjacent unit cell 20 is disposed. The first electrode 26 is electrically connected to the second electrode 21 of the adjacent unit cell 20 in the second dividing groove 18. In other words, the second dividing grooves 18 function as cell-connecting grooves.

Each of the unit cells 20 is an independent solar cell including an electron transport layer 25, a porous layer 24, a light-absorbing layer 23, and a hole transport layer 22, which form an n-i-p junction, and further including the first electrode 26 and the second electrode 21 both of which are output terminals.

The following is an explanation of an electrical connection of the unit cells 20 with reference to a certain unit cell 20 (first unit cell 20A) together with a second unit cell 20B and a third unit cell 20C both being adjacent to the first unit cell 20A.

The first electrode 26 of the first unit cell 20A is electrically connected to the second electrode 21 of the third unit cell 20C, where the second unit cell 20B and the third unit cell 20C are located each to be adjacent to the unit cell 20A. The second electrode 21 of the first unit cell 20A is electrically connected to the first electrode 26 of the second unit cell 20B. In this way, the unit cells 20 are electrically connected in series. The light-absorbing layers 23 are electrically connected in series. In FIG. 8B, the electrical connection is schematically depicted with a broken line 50L. Specifically, as indicated with the broken line 50L, a unit current path is repeatedly formed where a current flows from a light-absorbing layer 23 to another light-absorbing layer 23 via the hole transport layer 22, the second electrode 21, the porous layer 24, the electron transport layer 25, the first electrode 26, the electron transport layer 25, and the porous layer 24 in this order. Electric power can be obtained from one or a plurality of the first electrodes 26 and one or a plurality of the second electrodes 21. In FIG. 8B, an example of a power extraction position is schematically indicated with a diamond mark (◆). In an integrated solar cell module 50 having the unit cells 20, the light-absorbing layer 23 formed on the porous layer 24 is in contact with the first electrode 26 and the electron transport layer 25 within the first dividing groove 17, where the first electrode 26 and the electron transport layer 25 are layers provided below the porous layer 24.

The first photoelectric conversion body 111 may be configured according to the first configuration example. Every light-absorbing layer 23 extending in the longitudinal direction 152 as the length direction of the light-absorbing layer 23 can correspond to every first photoelectric conversion body 111 extending continuously. The spacing 23s may correspond to the third dividing groove 19, and may correspond to the first spacing 111s. The light-transmissive substrate 6 may correspond to the first substrate 113. The specific light transmittance of the first substrate 113 in the orthogonal direction 153 is higher than the specific light-transmittance of the first photoelectric conversion body 111 in the orthogonal direction 153.

The second photoelectric conversion body 121 may be configured according to the first configuration example. Every light-absorbing layer 23 extending in the longitudinal direction 152 as the length direction of the light-absorbing layer 23 can correspond to every second photoelectric conversion body 121 extending continuously. The spacing 23s may correspond to the third dividing groove 19, and may correspond to the second spacing 121s. The light-transmissive substrate 6 may correspond to the third substrate 123. The specific light transmittance of the third substrate 123 in the orthogonal direction 153 is higher than the specific light transmittance of the second photoelectric conversion body 121 in the orthogonal direction 153.

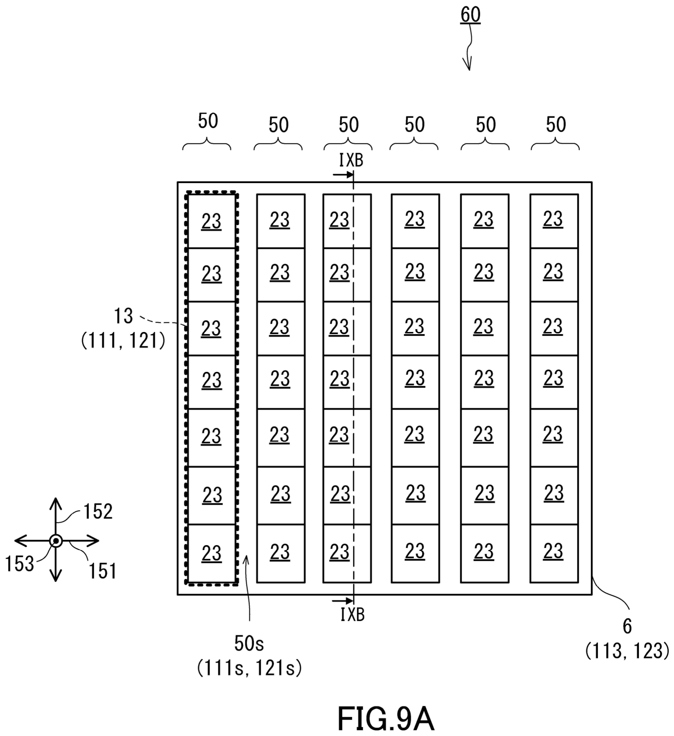

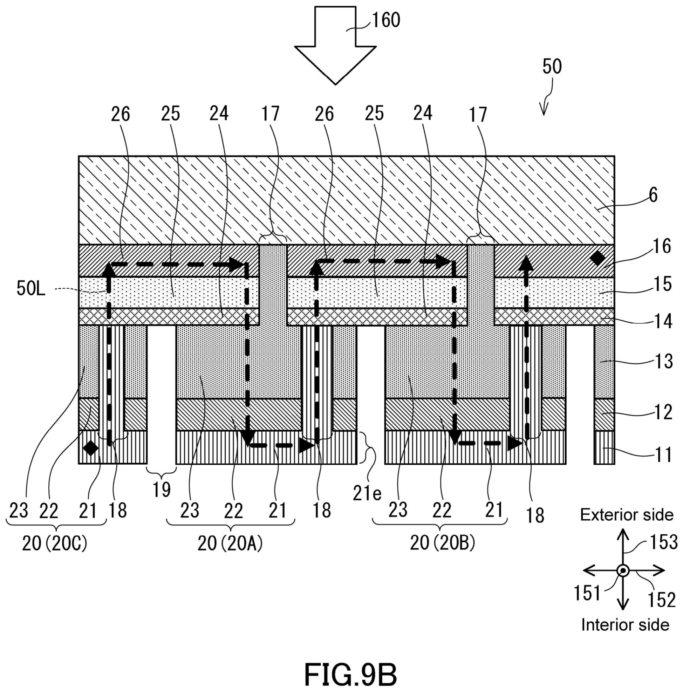

FIG. 9A is a plan view of a second configuration example where an integrated solar cell module 50 is used. FIG. 9B is a cross-sectional view of the second configuration example where the integrated solar cell module 50 is used. Specifically, FIG. 9B is a cross-sectional view of the integrated solar cell module 50 shown in FIG. 9A, taken along a line IXB-IXB and viewed in the direction indicated with a pair of arrows. In FIG. 9A, elements other than the light-absorbing layer 23 in the unit cell 20 are not shown. In FIG. 9B, part of the elements of the integrated solar cell module 50 is omitted. The second configuration example is described below. Hereinafter, elements common to the first configuration example and second configuration example are given the same reference numbers, and descriptions of those elements may be omitted.

As shown in FIG. 9A, the integrated solar cell modules 50 configure an array 60. In the array 60, the integrated solar cell modules 50 each extend in the longitudinal direction 152 as the length direction of the integrated solar cell module 50. The integrated solar cell modules 50 are aligned at a spacing 50s in the transverse direction 151.

As shown in FIG. 9B, in each integrated solar cell module 50, the first dividing grooves 17, the second dividing grooves 18, and the third dividing grooves 19 extend like stripes in the transverse direction 151.

In each integrated solar cell module 50, the unit cells 20 are electrically connected in series. The light-absorbing layers 23 are electrically connected in series. The light-absorbing layers 23 are aligned in the longitudinal direction 152.

As described above, in each of the integrated solar cell modules 50, a serially-connected body of the light-absorbing layers 23 is configured. In the array 60, the serially-connected bodies are electrically connected in series. There is no particular limitation for the aspect of connecting the serially-connected bodies in series.

The first photoelectric conversion body 111 may be configured on the basis of the second configuration example. The light-absorbing layers 23 aligned in the longitudinal direction 152 in one integrated solar cell module 50 can correspond to one first photoelectric conversion body 111 that extends intermittently. In other words, each light-absorbing layer 13 can correspond to each first photoelectric conversion body 111. The spacing 50s can correspond to the first spacing 111s.

The second photoelectric conversion body 121 may be configured on the basis of the second configuration example. The light-absorbing layers 23 aligned in the longitudinal direction 152 in one integrated solar cell module 50 can correspond to one second photoelectric conversion body 121 that extends intermittently. In other words, each light-absorbing layer 13 can correspond to each second photoelectric conversion body 121. The spacing 50s can correspond to the second spacing 121s.

Appropriate modifications can be applied to the configuration of the integrated solar cell module 50. For details of the integrated solar cell module 50, see Patent Literature 2, for example.

In the present embodiment, the interior window 110 includes a plurality of first photoelectric conversion bodies 111. The exterior window 120 includes a plurality of second photoelectric conversion bodies 121. The configuration in which both the interior window 110 and the exterior window 120 have a plurality of photoelectric converters is advantageous from the viewpoint of securing the electric power generated by the photovoltaic power generation system 100.

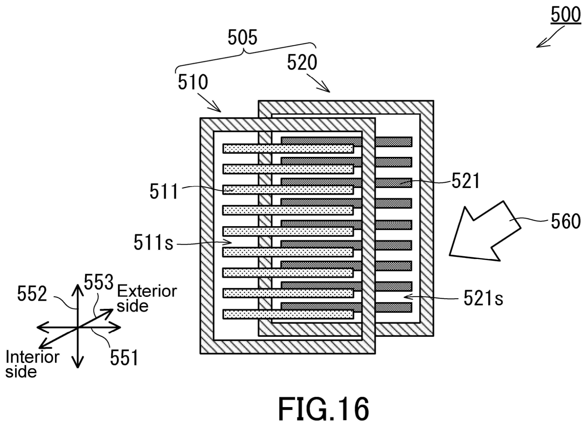

As can be understood from the above description, the first photoelectric conversion bodies 111 each extend in the longitudinal direction 152 as the length direction of the first photoelectric conversion body 111. A direction in which the first photoelectric conversion bodies 111 are aligned is the transverse direction 151. The second photoelectric conversion bodies 121 each extend in the longitudinal direction 152 as the length direction of the second photoelectric conversion body 121. A direction in which the second photoelectric conversion bodies 121 are aligned is the transverse direction 151. A window frame 109 guides a relative move of the exterior window 120 with respect to the interior window 110 in the transverse direction 151. This configuration is capable of achieving both power generation and an aesthetic appearance. The reason will be described below by referring to FIG. 16, FIG. 17A, FIG. 17B, FIG. 2A, FIG. 2B and FIG. 2C.

That is, in the case of imparting the windows with light transmissivity and power-generating function, each window may be partially provided with photoelectric conversion bodies.

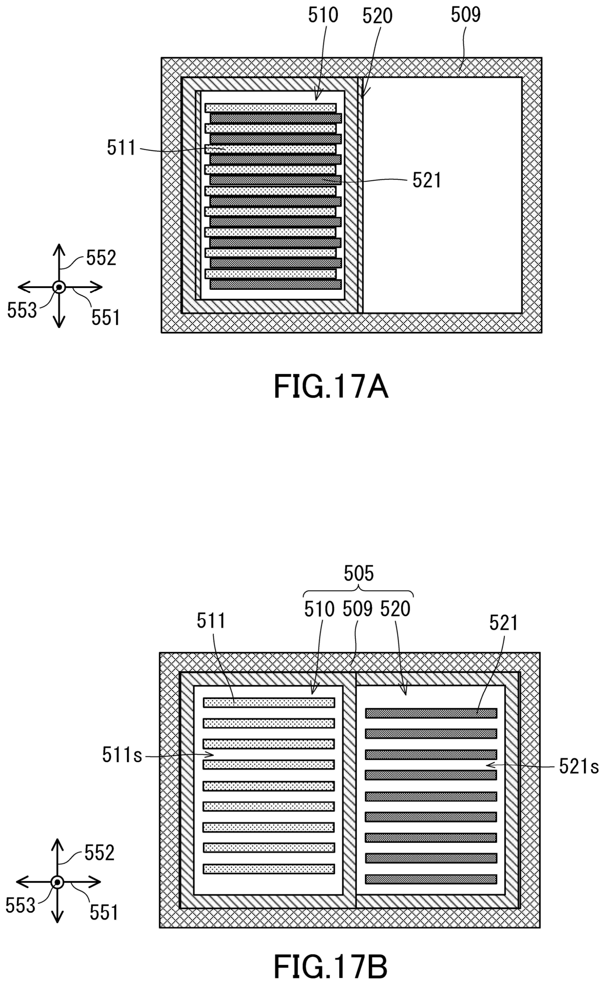

FIG. 16 is an explanatory diagram of the photovoltaic power generation system 500 according to the first reference example. FIG. 17A and FIG. 17B are diagrams of the photovoltaic power generation system 500 according to the first reference example as viewed from the orthogonal direction 553. The photovoltaic power generation system 500 includes a window unit 505. The window unit 505 includes a window frame 509, an interior window 510, and an exterior window 520. In the window unit 505 of the first reference example, a sliding window is configured.

In FIG. 16, a transverse direction (first direction) 551, a longitudinal direction (second direction) 552, and an orthogonal direction (third direction) 553 are shown. The transverse direction 551, the longitudinal direction 552, and the orthogonal direction 553 are mutually orthogonal directions. In the reference example 1, the transverse direction 551 is the direction for opening/closing the window unit 505. The window unit 505 is opened and closed by moving at least one selected from the group consisting of the interior window 510 and the exterior window 520 in the transverse direction 551. The orthogonal direction 553 is a direction from the exterior to the interior or from the interior to the exterior.

The interior window 510 has a plurality of first photoelectric conversion bodies 511. The first photoelectric conversion bodies 511 each are electrically connected in series. The first photoelectric conversion bodies 511 each extend in the transverse direction 551 as the length direction of the first photoelectric conversion body 511. The first photoelectric conversion bodies 511 are aligned in the longitudinal direction 552 at a first spacing 511s.

The exterior window 520 has a plurality of second photoelectric conversion bodies 521. The second photoelectric conversion bodies 521 each are electrically connected in series. The second photoelectric conversion bodies 521 each extend in the transverse direction 551 as the length direction of the second photoelectric conversion body 521. The second photoelectric conversion bodies 521 are aligned in the longitudinal direction 552 at a second spacing 521s.

In the photovoltaic power generation system 500 according to the first reference example, even if the window unit 505 is opened, power generation by the first photoelectric conversion bodies 511 in the interior window 510 is unlikely to be hindered. FIG. 17A shows the state where the window unit 505 is open. As can be understood from FIG. 17A, in the photovoltaic power generation system 500 according to the first reference example, when the window unit 505 is open, that is, when the interior window 510 and the exterior window 520 overlap with each other, the first photoelectric conversion bodies 511 and the second photoelectric conversion bodies 521 are aligned alternately in the longitudinal direction 552. As a result, while sunlight 560 travels toward the interior from the exterior, it is possible to prevent the first photoelectric conversion bodies 511 from being positioned in the shadow of the second photoelectric conversion bodies 521. This is advantageous from the viewpoint of allowing the first photoelectric conversion bodies 511 on the interior window 510 to generate electric power.

In the meantime, in the photovoltaic power generation system 500 according to the first reference example, the aesthetic appearance of the window unit 505 may be impaired when the window unit 505 is closed. FIG. 17B shows the state in which the window unit 505 is closed. As can be understood from FIG. 17B, in the photovoltaic power generation system 500 according to the first reference example, when the window unit 505 is closed, the longitudinal positions 552 of the first photoelectric conversion bodies 511 and the longitudinal position 552 of the second photoelectric conversion bodies 521 will be misaligned. This misalignment will deteriorate aesthetic appearance of the window unit 505.

It is assumed here that the positions of the first photoelectric conversion bodies 511 and the second photoelectric conversion bodies 521 are adjusted to be aligned in the longitudinal direction 552. Such a position adjustment may improve the aesthetic appearance of the window unit 505 in a closed state. However, this position adjustment may cause a problem. That is, in the case where the window unit 505 is open in the presence of the sunlight 560 (when the interior window 510 and the exterior window 520 overlap with each other), the first photoelectric conversion bodies 511 are positioned in the shadow of the second photoelectric conversion bodies 521. This may hinder power generation by the first photoelectric conversion bodies 511.

This indicates that it is not easy to achieve both the aesthetic appearance and the electricity output of the first photoelectric conversion bodies 511 and the second photoelectric conversion bodies 521.

In contrast, in the above configuration according to the present embodiment, the direction of relative move of the interior window 110 and the exterior window 120 is not the longitudinal direction of the first photoelectric conversion bodies 111 and the second photoelectric conversion bodies 121, but the direction coincides with the direction in which each of the first photoelectric conversion bodies 111 and the second photoelectric conversion bodies 121 are aligned. With this configuration, even in a case of increasing the degree of opening of the window unit 105, the conversion body overlapping area can be reduced as shown in FIG. 2B, rather than FIG. 2C. In this way, power generation by the first photoelectric conversion bodies 111 is less likely to be hindered, making it easier to obtain electric power. Even in a case where the window unit 105 is closed as shown in FIG. 2A, there may be no misalignment of the first photoelectric conversion bodies 111 and the second photoelectric conversion bodies 121 in the longitudinal direction 152, as explained with reference to FIG. 17B. Therefore, even in the case where the window unit 105 is closed, the aesthetic appearance of the window unit 105 is unlikely to be impaired. As a result, this configuration can achieve both the aesthetic appearance and the electricity output of the first photoelectric conversion bodies 111 and the second photoelectric conversion bodies 121.

Here, the overlapping area of the interior window 110 and the exterior window 120 when viewed from the orthogonal direction 153 is defined as the window overlapping area (structure overlapping area). The overlapping area of the first photoelectric conversion bodies 111 and the second photoelectric conversion bodies 121 when viewed from the orthogonal direction 153 is defined as a conversion body overlapping area. In this case, a relative move that increases the window overlapping area alternately achieves a state in which the conversion body overlapping area is at a peak value and a state in which the conversion body overlapping area is at a bottom value.

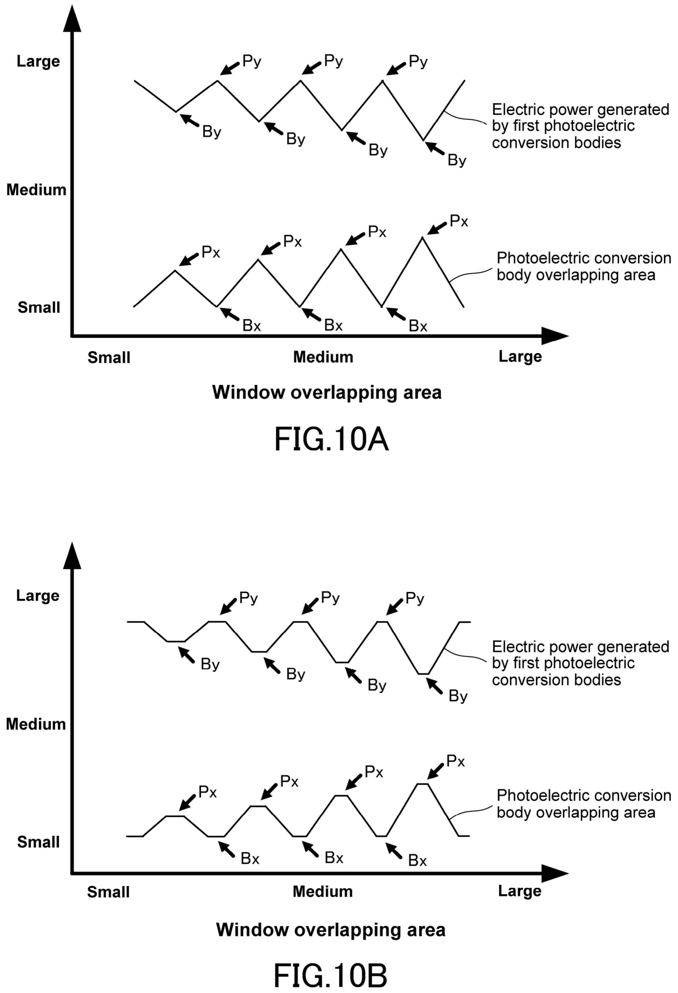

The term "peak value" means a local maximum value. The term "bottom value" means a local minimum value. Hereinafter, the expressions "peak value" and "bottom value" of the conversion body overlapping area will be specified with reference to FIG. 10A and FIG. 10B. FIG. 10A and FIG. 10B are explanatory diagrams of the peak value and the bottom value. In FIG. 10A and FIG. 10B, the horizontal axis indicates a window overlapping area. The horizontal axis shows that the window overlapping area is smaller on the left and larger on the right. In general, the state in FIG. 2A is a situation where the window overlapping area is small, and the state in FIG. 2B and FIG. 2C is a situation where the window overlapping area is large.

As shown in FIG. 10A and FIG. 10B, when the window overlapping area increases, the conversion body overlapping area repeatedly increases and decreases. The conversion body overlapping area repeatedly increases and decreases to alternately take on a peak value Px and a bottom value Bx. In the example shown in FIG. 10A, during the increase in the window overlapping area, the peak value Px appears at the point where the conversion body overlapping area stops increasing and starts decreasing, and the bottom value Bx appears at the point where the conversion body overlapping area stops decreasing and starts increasing. In the example shown in FIG. 10B, during the increase in the window overlapping area, regions where the conversion body overlapping area is maintained at the peak value Px and regions where the conversion body overlapping area is maintained at the bottom value Bx appear alternately. As can be understood from the example in FIG. 10A and FIG. 10B, the peak value Px and the bottom value Bx of the window overlapping area may appear as a point value (FIG. 10A) in response to changes in the conversion body overlapping area, or may appear to be maintained at a constant value (FIG. 10B) when the window overlapping area is within a certain range. The bottom value Bx may be zero or may not be zero.

As shown in FIG. 10A and FIG. 10B, when the window overlapping area increases, the electric power generated by the first photoelectric conversion bodies 111 can repeatedly increase and decrease. The generated electric power can repeatedly increase and decrease, thereby alternately taking on the peak values Py and the bottom values By. In the example shown in FIG. 10A, during the increase in the window overlapping area, the peak value Py appears at the point where the generated electric power stops increasing and starts decreasing, and the bottom value By appears at the point where the generated electric power stops decreasing and starts increasing. In the example shown in FIG. 10B, during the increase in the overlapping area of the window, regions where the generated electric power is maintained at the peak value Py and regions where the generated electric power is maintained at the bottom value By appear alternately. As can be understood from the example in FIG. 10A and FIG. 10B, the peak value Py and the bottom value By of the electric power generated by the first photoelectric conversion bodies 111 may appear as a point value (FIG. 10A) in response to changes in the overlapping area of the window, or may appear to be maintained at a constant value (FIG. 10B) when the overlapping area of the window is within a certain range.

The window overlapping area at the time the conversion body overlapping area reaches the peak value Px may coincide with or may be misaligned from the window overlapping area at the time the electric power generated by the first photoelectric conversion bodies 111 reaches the bottom value By. The window overlapping area at the time the conversion body overlapping area reaches the bottom value Bx may coincide with or may be misaligned from the window overlapping area at the time the electric power generated by the first photoelectric conversion bodies 111 reaches the peak value Py. For example, the coincidence can occur in a case where the incident direction of sunlight 160 is the same as the orthogonal direction 153. The misalignment can occur, for example, when the incident direction of the sunlight 160 deviates from the orthogonal direction 153. The incident direction of the sunlight 160 can be determined by a period of the time of day, the buildings in the vicinity of the building having the window unit 105, the terrain, trees, or the like.

In the present embodiment, the photovoltaic power generation system 100 includes a control device 140. The control device 140 controls a relative move such that the electric power generated by the first photoelectric conversion bodies 111 and/or the conversion body overlapping area changes.

Specifically, the control device 140 controls the relative move such that the electric power generated by the first photoelectric conversion bodies 111 approaches the peak value Py and/or the conversion body overlapping area approaches the bottom value Bx. As a result, a large electric power can be generated. More specifically, the control device 140 controls the relative move such that the electric power generated by the first photoelectric conversion bodies 111 reaches the peak value Py and/or the conversion body overlapping area reaches the bottom value Bx.

The control device 140 may control the relative move such that the electric power generation by the first photoelectric conversion bodies 111 approaches the peak value Py. With this control, it is possible to obtain generated electric power regardless of the incident direction of the sunlight 160.

The control device 140 may control the relative move such that the interior window 110 and the exterior window 120 overlap with each other at least partially when viewed from the orthogonal direction 153 and that the electric power generated by the first photoelectric conversion bodies 111 increases. The control device 140 may control the relative move such that the interior window 110 and the exterior window 120 overlap with each other at least partially when viewed from the orthogonal direction 153 and that the conversion body overlapping area decreases. "The interior window 110 and the exterior window 120 overlap with each other at least partially" may be specified as "the exterior window 120 is disposed in a region accounting for 50% or more of the area of the interior window 110".

Specifically, the control device 140 may control relative move such that the interior window 110 and the exterior window 120 overlap with each other at least partially when viewed from the orthogonal direction 153 and that the electric power generated by the first photoelectric conversion bodies 111 approaches the peak value Py. The control device 140 may control the relative move such that the interior window 110 and the exterior window 120 overlap with each other at least partially when viewed from the orthogonal direction 153 and that the conversion body overlapping area approaches the bottom value Bx.

Here, a sum of areas of the first photoelectric conversion bodies 111 when viewed from the orthogonal direction 153 is defined as a first total area. A sum of areas of the second photoelectric conversion bodies 121 when viewed from the orthogonal direction 153 is defined as a second total area. A sum of the first total area and the second total area is defined as a reference area. An area obtained by subtracting the conversion body overlapping area from the reference area is defined as an effective area. A ratio of the effective area to the reference area is defined as an effective ratio. In the present embodiment, the state achieved by the relative move includes a state in which the effective ratio is 80% or more and 100% or less.

The state achieved by the relative move may include a state in which the effective ratio is 50% or more and 60% or less. As can be understood from FIG. 2C, the state achieved by the relative move may include a state in which the first photoelectric conversion bodies 111 are disposed in a region of 100% of the area of the second photoelectric conversion bodies 121 when viewed from the orthogonal direction 153.

As can be understood from FIG. 2B, the state achieved by the relative move may include a state in which the effective ratio is 100%. In other words, the state achieved by the relative move may include a state in which the second photoelectric conversion bodies 121 do not overlap with the first photoelectric conversion bodies 111 when viewed from the orthogonal direction 153. The state achieved by the relative move may include a state in which at least two of the first photoelectric conversion bodies 111 and at least two of the second photoelectric conversion bodies 121 are aligned alternately in the transverse direction 151 when viewed from the orthogonal direction 153.

The definitions of various dimensions are restated below.
- A dimension W1a is a dimension of the first photoelectric conversion body 111 in the transverse direction 151.
- A dimension L1a is a dimension of the first photoelectric conversion body 111 in the longitudinal direction 152.
- A dimension T1a is a dimension of the first photoelectric conversion body 111 in the orthogonal direction 153.
- A dimension W2a is a dimension of the second photoelectric conversion body 121 in the transverse direction 151.
- A dimension L2a is a dimension of the second photoelectric conversion body 121in the longitudinal direction 152.
- A dimension T2a is a dimension of the second photoelectric conversion body 121 in the orthogonal direction 153.

In the present embodiment, at least one of the first requirement (1) and the second requirement (2) below is satisfied. This allows the interior window 110 and the exterior window 120 to have degrees of freedom such that these windows can have configurations independent from each other. This allows the interior window 110 and the exterior window 120 to have different characteristics. The characteristics are, for example, power generation characteristics, light transmission characteristics or the like. Both the first requirement and the second requirement may be satisfied. In the following context, the first spacing 111s and the second spacing 121s are the dimensions in the transverse direction 151.
(1) The first requirement is that the dimension W1a and the dimension W2a are different from each other.
(2) The second requirement is that the first spacing 111s and the second spacing 121s are different from each other.

As can be understood from FIG. 2A and FIG. 2B, in the present embodiment, the dimension W1a is larger than the dimension W2a. According to this dimensional relation, the incidence of the sunlight 160 from outdoors to the first photoelectric conversion body 111 is less likely to be blocked by the second photoelectric conversion body 121. For example, the dimension W1a is more than 100% and 140% or less of the dimension W2a. The dimension W1a may be more than 100% and 120% or less of the dimension W2a, or may be more than 110% and 120% or less of the dimension W2a.

However, in the case where the dimensions are different as described above, the appearance of the interior window 110 and the appearance of the exterior window 120 may differ when the window unit 105 is closed as shown in FIG. 2A. Therefore, in the present embodiment, a configuration is adopted in which the specific light transmittance of the first photoelectric conversion body 111 in the orthogonal direction 153 is larger than the specific light transmittance of the second photoelectric conversion body 121 in the orthogonal direction 153. The difference in appearance can be reduced when the specific light transmittance has such a relationship.

The dimensional relationship as described above is not essential. The dimension W1a may be larger than the dimension W2a, may be the same as the dimension W2a, or may be smaller than the dimension W2a. The relationship in the specific light transmittance in the orthogonal direction 153 is not essential. The specific light transmittance of the first photoelectric conversion body 111 in the orthogonal direction 153 may be higher than the specific light transmittance of the second photoelectric conversion body 121 in the orthogonal direction 153, may be the same as the specific light transmittance of the second photoelectric conversion body 121 in the orthogonal direction 153, or may be lower than the specific light transmittance of the second photoelectric conversion body 121 in the orthogonal direction 153. Another adoptable configuration is that the dimension W1a is smaller than or equal to the dimension W2a and the specific light transmittance of the first photoelectric conversion body 111 in the orthogonal direction 153 is higher than the specific light transmittance of the second photoelectric conversion body 121 in the orthogonal direction 153.

The dimension T1a may be smaller than the dimension T2a. In this case, the specific light transmittance of the first photoelectric conversion body 111 in the orthogonal direction 153 is more likely to be larger than the specific light transmittance of the second photoelectric conversion body 121 in the orthogonal direction 153. The dimension T1a may be the same as the dimension T2a, or may be larger than the dimension T2a.

In the present embodiment, the dimension L2a is the same as the dimension L1a. The dimension L2a may be larger than the dimension L1a. The dimension L2a may be smaller than the dimension L1a. The dimension W1b is, for example, 80% or more and 120% or less of the dimension W2b. The dimension W1b may be 90% or more and 110% or less of the dimension W2b. The dimension W1b may be larger than the dimension W2b, may be the same as the dimension W2b, or may be smaller than the dimension W2b.

As described above, both the interior window 110 and the exterior window 120 may be configured with the first photoelectric conversion body 111 and the second photoelectric conversion body 121 on the basis of the first configuration example shown in FIG. 8A and FIG. 8B or the second configuration example shown in FIG. 9A and FIG. 9B. In the configuration of FIG. 8A to FIG. 9B in this case, a part of the second electrode 21, the part having a film shape in the orthogonal direction 153 as the thickness direction, is defined as a back face electrode layer 21e. A thickness of the back face electrode layer 21e of the interior window 110 (dimension in the orthogonal direction 153) may be smaller than a thickness of the back face electrode layer 21e of the exterior window 120. In this way, the specific light transmittance of the back face electrode layer 21e of the interior window 110 in the orthogonal direction 153 may be easily made higher than the specific light transmittance of the back face electrode layer 21e of the exterior window 120. Such a difference for the specific light transmittance is advantageous from the viewpoint of reducing the difference between the appearance of the interior window 110 and the appearance of the exterior window 120 when the dimension W1a is larger than the dimension W2a. In the examples shown in FIG. 8A to FIG. 9B, the back face electrode layer 21e is the part of the second electrode 21 that is located opposite to the light-absorbing layer 23 when viewed from the hole transport layer 22.

The thickness of the light-absorbing layer 23 of the interior window 110 (the dimension in the direction 153) may be smaller than the thickness of the light-absorbing layer 23 of the exterior window 120. In this way, the specific light transmittance of the light-absorbing layer 23 of the interior window 110 in the orthogonal direction 153 may be easily made larger than the specific light transmittance of the light-absorbing layer 23 of the exterior window 120. It is also possible to set the aforementioned variation in the thickness of the light-absorbing layer 23 and to set the aforementioned variation in the thickness of the back face electrode layer 21e.

The thickness of the back face electrode layer 21e of the interior window 110 may be the same as the thickness of the back face electrode layer 21e of the exterior window 120, or may be larger than the thickness of the back face electrode layer 21e of the exterior window 120.

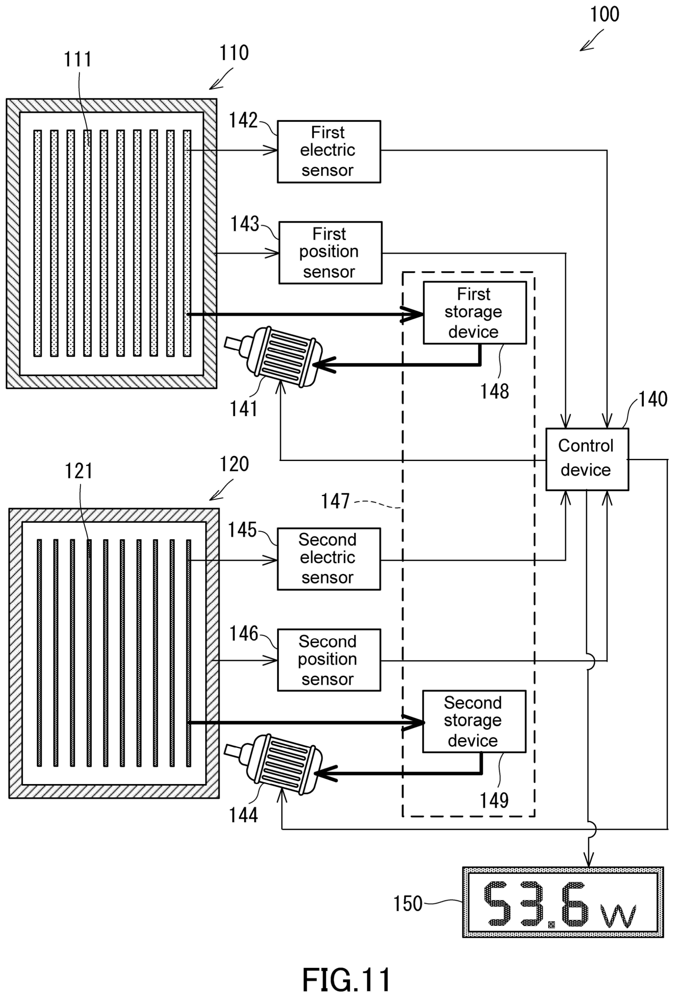

FIG. 11 is an explanatory diagram of the electrical system and the control system of the photovoltaic power generation system 100 of Embodiment 1. The photovoltaic power generation system 100 includes a control device 140, a first motor 141, a second motor 144, a first electric sensor 142, a first position sensor 143, a second electric sensor 145, a second position sensor 146, a power storage device 147, and a display 150. The power storage device 147 includes a first power storage device 148 and a second power storage device 149. The first electric sensor 142, the first position sensor 143, the second electric sensor 145, and the second position sensor 146 communicate with the control device 140, and specifically, transmit detection signals to the control device 140.

The control device 140 controls the relative move of the exterior window 120 in the transverse direction 151 with respect to the interior window 110. In this way, the relative position of the exterior window 120 in the transverse direction 151 is controlled with respect to the interior window 110. The control of the relative move may be a control of a move of at least one of the interior window 110 and the exterior window 120.

The first motor 141 moves the interior window 110 in the transverse direction 151. The second motor 144 moves the exterior window 120 in the transverse direction 151. The control device 140 controls the relative move of the interior window 110 and the exterior window 120 in cooperation with at least one selected from the group consisting of the first motor 141 and the second motor 144. One of the first motor 141 and the second motor 144 may be omitted.

The power storage device 147 is supplied with at least one of the electric power generated by the first photoelectric conversion bodies 111 and the electric power generated by the second photoelectric conversion bodies 121. In the example shown in FIG. 11, the power storage device 147 is supplied with both the electric power generated by the first photoelectric conversion bodies 111 and the electric power generated by the second photoelectric conversion bodies 121. Specifically, the electric power generated by the first photoelectric conversion bodies 111 is supplied to the first storage device 148. The electric power generated by the second photoelectric conversion bodies 121 is supplied to the second storage device 149.

At least one of the first motor 141 and the second motor 144 is supplied with electric power from the storage device 147. In the example shown in FIG. 11, both the first motor 141 and the second motor 144 are supplied with electric power from the storage device 147. Specifically, the first motor 141 is supplied with electric power from the first storage device 148. The second motor 144 is supplied with electric power from the second storage device 149.

In the example shown in FIG. 11, the first storage device 148 and the second storage device 149 are separated from each other. The first storage device 148 and the second storage device 149 may be configured as a single unit. The storage device 147 may be composed only of the first storage device 148, or may be composed only of the second storage device 149. The photovoltaic power generation system 100 may be configured such that the storage device 147 supplies electric power to only one of the first motor 141 and the second motor 144.

As one configuration example, the interior window 110 is configured to include the first storage device 148 and the first motor 141. Therefore, the first storage device 148 and the first motor 141 move in the transverse direction 151 together with the first photoelectric conversion bodies 111. Meanwhile, the exterior window 120 is configured to include the second storage device 149 and the second motor 144. Therefore, the second storage device 149 and the second motor 144 move in the transverse direction 151 together with the second photoelectric conversion bodies 121.

The first storage device 148 and the first motor 141 may be provided outside the interior window 110. The second storage device 149 and the second motor 144 may be provided outside the exterior window 120.

A specific sensor generates a detection value corresponding to the power generation by the first photoelectric conversion bodies 111. The specific sensor may be, for example, any of a current sensor, a voltage sensor, and a power sensor. The detection value may be any of a current value, a voltage value, and a power value.

In the example shown in FIG. 11, the specific sensor generates a detection value corresponding to the power generation by the first photoelectric conversion bodies 111 and the second photoelectric conversion bodies 121. Specifically, the detection value is a current value, a voltage value, or a power value of the first photoelectric conversion bodies 111 and the second photoelectric conversion bodies 121.

In a first control example, the control device 140 controls the relative move of the interior window 110 and the exterior window 120 in cooperation with the specific sensor. According to the first control example, the control device 140 can control the relative move of the interior window 110 and the exterior window 120 in accordance with the detection value of the specific sensor such that the electric power generated by the first photoelectric conversion bodies 111 changes. Specifically, the control device 140 can control the relative move of the interior window 110 and the exterior window 120 so that the electric power generated by the first photoelectric conversion bodies 111 approaches the peak value Py.

In the second control example, the control device 140 controls the relative move of the interior window 110 and the exterior window 120 in cooperation with at least one selected from the group consisting of the first position sensor 143 and the second position sensor 146. The first position sensor 143 detects the position of the interior window 110 in the window unit 105. The second position sensor 146 detects the position of the exterior window 120 in the window unit 105. According to the second control example, the relative move of the interior window 110 and the exterior window 120 can be controlled such that the conversion body overlapping area changes in accordance with the detection value of the first position sensor 143 and/or the detection value of the second position sensor 146. Specifically, the control device 140 can control the relative move of the interior window 110 and the exterior window 120 such that the conversion body overlapping area approaches the bottom value Bx.

The control device 140 may cooperate with the specific sensor and further at least one selected from the group consisting of the first position sensor 143 and the second position sensor 146. In this case, for example, the control device 140 cooperates with at least one selected from the group consisting of the first position sensor 143 and the second position sensor 146 so as to control the relative move such that the relative positions of the interior window 110 and the exterior window 120 are within a target range. Next, the control device 140 cooperates with the specified sensor and also with at least one sensor selected from the group consisting of the first position sensor 143 and the second position sensor 146, thereby controlling the relative move of the interior window 110 and the exterior window 120 such that the electric power generated by the first photoelectric conversion bodies 111 approaches the peak value Py and the relative position is maintained within the target range.

One or more of the first electric sensor 142, the first position sensor 143, the second electric sensor 145, and the second position sensor 146 may be omitted. The specific sensor may be omitted.

The display 150 displays visualization information in response to the power generation by the first photoelectric conversion bodies 111. The term "power generation" may refer to generated current, generated voltage, or generated electric power. In the example shown in FIG. 11, the visualization information is the detection value corresponding to the aforementioned power generation by the first photoelectric conversion bodies 111. The specific sensor generates a signal representing the detection value. The display 150 receives this signal from the control device 140 and displays the detection value on the basis of the received signal. Specifically, in the example shown in FIG. 11, the generated electric power is displayed as a number as the visualization information. The display 150 can be a digital display. The visualization information may be displayed in a digital form.

In another example, the display 150 includes at least one lamp. The visualization information is brightness of the lamp. For example, the brightness of the lamp changes in accordance with the power generation by the first photoelectric conversion bodies 111. The state in which the brightness of the lamp is zero can also be a state in which the visualization information is displayed. A change in the brightness of the lamp encompasses that the state in which the lamp is not lit changes to a state in which the lamp is lit. Specifically, the lamp may be turned on when the electric power generated by the first photoelectric conversion bodies 111 is at a peak value Py. The lamp may be controlled by the control device 140.

In the above description, the term "electric power" is used to explain the technique. Unless there is a particular contradiction, "electric power" may be read as "electric energy". For example, the relative move of the interior window 110 and the exterior window 120 may be controlled on the basis of the electric power generated by the first photoelectric conversion bodies 111, and the relative move of the interior window 110 and the exterior window 120 may be controlled on the basis of the electric energy generated by the first photoelectric conversion bodies 111. Here, the unit of electric power is watt (W), and the electric energy is the time integral of electric power, and the unit of electric energy is expressed in units of watt-seconds (Ws) or watt-hours (Wh). These definitions will apply to the terms "electric power" and "electric energy".

The following control method for controlling the power generation system is derived from the above description. The control method is carried out by the control device 140, for example. The control method is explained below. In the following explanation, the power generation system can be a solar power generation system 100 specifically. The above explanation for the solar power generation system 100 can be applied to the technique of the following control method.

In the power generation system, the interior window (first structure) 110 is disposed closer to an interior side than an exterior window (second structure) 120. In the control method, at least one of the electric power generated by the interior window 110 and the electric energy generated by the interior window 110 is changed by changing the overlapping area where the first photoelectric conversion bodies 111 and the second photoelectric conversion bodies 121 overlap one another. The electric power generated by the interior window 110 is, specifically, electric power generated by the first photoelectric conversion bodies 111. The electric energy generated by the interior window 110 is, specifically, electric energy generated by the first photoelectric conversion bodies 111.

In the control method, the overlapping area is changed by changing the relative position of the interior window 110 and the exterior window 120.

In the control method, it is possible to change the overlapping area such that the generated electric power or the generated electric energy tracks a target value.

Other embodiments will be described below. In the following, the same reference symbols are used for elements that are common to the embodiment described above and the embodiment to be described later, and the description of these elements may be omitted. The description for the respective embodiments may be applied mutually unless there is a technical contradiction. The embodiments may be combined with each other unless there is a technical contradiction.

### (Embodiment 2)

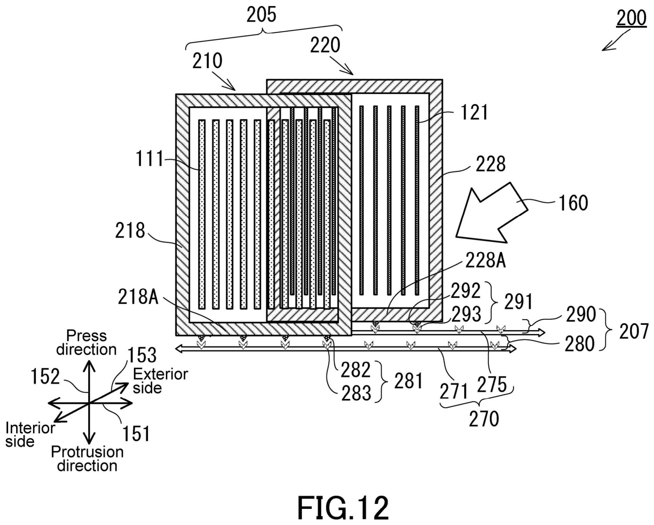

FIG. 12 is an explanatory diagram of a photovoltaic power generation system 200 according to Embodiment 2.

In Embodiment 2, the photovoltaic power generation system 200 includes a mechanical lock 207. The mechanical lock 207 fixes the relative position of the exterior window 220 with respect to the interior window 210 such that the conversion body overlapping area remains at the bottom value Bx. This fixing function can be exhibited, for example, when a human being is manually moving at least one of the group consisting of the interior window 210 and the exterior window 220.

The mechanical lock 207 can fix the relative positions of the interior window 210 and the exterior window 220 such that the interior window 210 and the exterior window 220 overlap with each other at least partially when viewed from the orthogonal direction 153 and such that the conversion body overlapping area deviates from the peak value Px. "The interior window 210 and the exterior window 220 overlap with each other at least partially" may be specifically expressed as "the exterior window 220 is disposed in a region accounting for 50% or more of the area of the interior window 210".

Specifically, the mechanical lock 207 can fix the relative positions of the interior window 210 and the exterior window 220 such that the interior window 210 and the exterior window 220 overlap with each other at least partially when viewed from the orthogonal direction 153 and the conversion body overlapping area is the bottom value Bx.

The mechanical lock 207 includes at least one selected from the group consisting of a first lock 280 and a second lock 290. In the example shown in FIG. 12, the mechanical lock 207 includes both the first lock 280 and the second lock 290. The first lock 280 fixes stepwise the interior window 210 at a plurality of positions that are different from each other with respect to the transverse direction 151. The second lock 290 fixes stepwise the exterior window 220 at a plurality of positions that differ from each other with respect to the transverse direction 151.

The guide 270 has a first groove 271 and a third groove 275. The first lock 280 is provided in the first groove 271 and in the interior window 210. The second lock 290 is provided in the third groove 275 and in the exterior window 220.

The first lock 280 includes a plurality of first latches 281. The first latches 281 each have a first main body 282 and a first strike plate 283. In the present embodiment, the first latches 281 are spring latches or "tobane" in Japanese. The spring latch can also be referred to as "gombe" in Japanese.

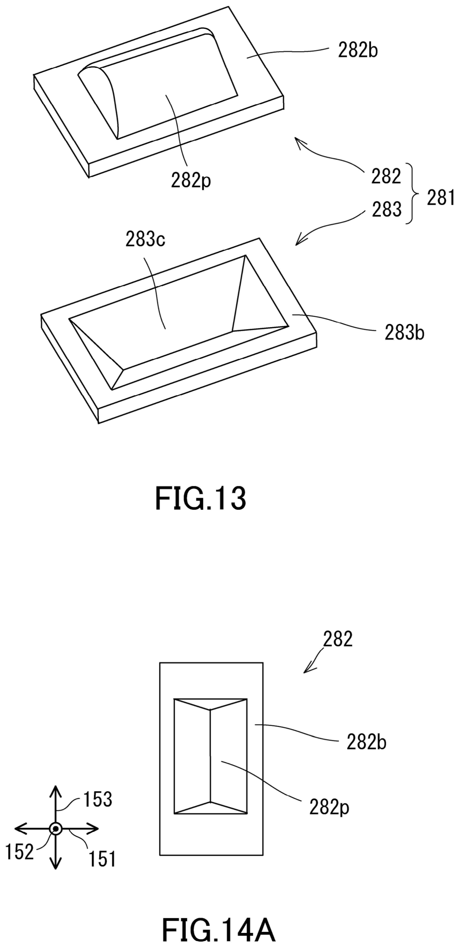

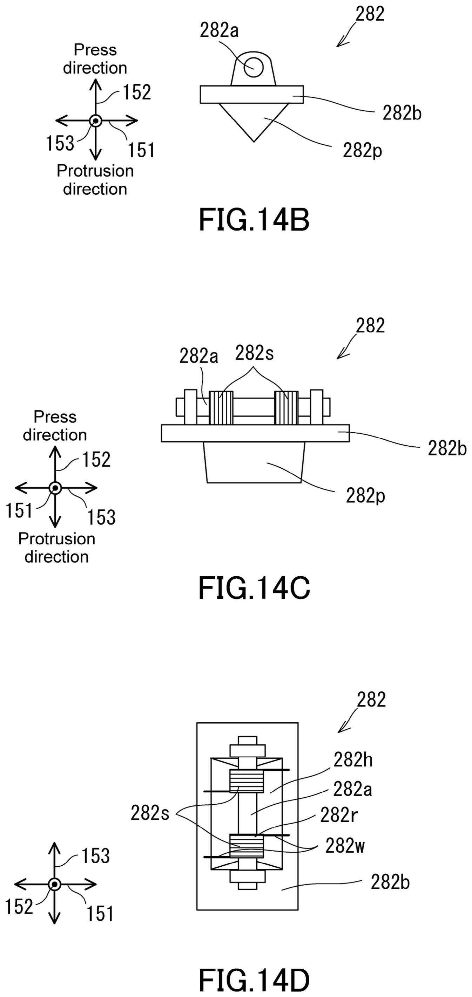

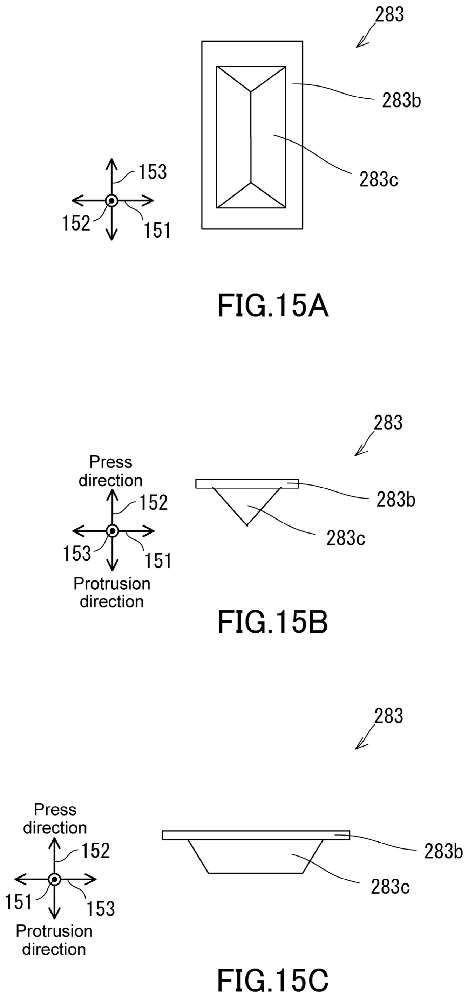

FIG. 13 is an explanatory diagram of the first latch 281. FIG. 14A, FIG. 14B, FIG. 14C and FIG. 14D are diagrams of the first main body 282 viewed from the longitudinal direction 152, the orthogonal direction 153, the transverse direction 151 and the longitudinal direction 152, respectively. FIG. 15A, FIG. 15B, and FIG. 15C are diagrams of the first strike plate 283 viewed from the longitudinal direction 152, the orthogonal direction 153, and the transverse direction 151, respectively.

The direction from one end to the other end of the longitudinal direction 152 may be sometimes referred to as a protrusion direction. The direction from the other end to the one end of the longitudinal direction 152 may be sometimes referred to as a press direction. FIG. 14A is a diagram of a first main body 282 viewed from the other end in the longitudinal direction 152. FIG. 14D is a diagram of the first main body 282 viewed from the one end in the longitudinal direction 152. FIG. 15A is a diagram of a first strike plate 283 viewed from one end in the longitudinal direction 152.

The first main body 282 includes a first base 282b, a first protrusion 282p, a first shaft 282a, and two first springs 282s. As shown in FIG. 14A to FIG. 14C, the first protrusion 282p protrudes from the first base 282b in the protrusion direction. As shown in FIG. 14D, the first inner space 282h is formed within the first protrusion 282p. The first shaft 282a is provided in the first base 282b to bridge over the first inner space 282h. The first springs 282s each include a first wound portion 282r and two drawn portions 282w. The first wound portion 282r is wound around the first shaft 282a. The drawn portions 282w are drawn out from the first wound portion 282r. The drawn portion 282w is getting in contact with the first base 282b. When the first protrusion 282p is applied with a pressing force in the press direction, the first protrusion 282p is pressed in the press direction. In this state, the first springs 282s form a repulsive force to push the first protrusion 282p back in the protrusion direction. When the pressing force is removed, the first protrusion 282p returns to the state of protruding from the first base 282b in the protrusion direction due to the repulsive force.

A strike plate 283 includes a second base 283b and a first recess 283c. As shown in FIG. 15A to FIG. 15C, in the first strike plate 283, the first recess 283c is recessed from the second base 283b in the protrusion direction. When the first protrusion 282p enters into the first recess 283c, the first main body 282 and the first strike plate 283 engage with each other, and the fixing function of the first latch 281 is exhibited.

In the example shown in the attached drawings, the first latch 281 is a triangular spring latch. When viewed from the orthogonal direction 153, the first protrusion 282p and the first recess 283c are triangular.

A second lock 290 includes a plurality of second latches 291. Each of the second latches 291 has a second main body 292 and a second strike plate 293. In the present embodiment, the second latches 291 are spring latches.

The description of the first latches 281 with reference to FIG. 13 to FIG. 15C can also be applied to the second latches 291. In this application, the description of the first latches 281 can be read as the second latches 291, the first main body 282 as the second main body 292, and the first strike plate 283 as the second strike plate 293, for example, as appropriate.

As can be understood from FIG. 12, in the first frame member 218A of the first support frame 218 of the interior window 210, a plurality of first main bodies 282 are aligned in the transverse direction 151. In a first groove 271, a plurality of first strike plates 283 are aligned in the transverse direction 151. The pitch at which the first main bodies 282 are aligned in the transverse direction 151 is the same as the pitch at which the first strike plates 283 are aligned in the transverse direction 151. In this way, in the example shown in FIG. 12, the first lock 280 is provided in the window unit 205.

In a fifth frame member 228A of the second support frame 228 of the exterior window 220, a plurality of second main bodies 292 are aligned in the transverse direction 151. In a third groove 275, a plurality of second strike plates 293 are aligned in the transverse direction 151. The pitch at which the second main bodies 292 are aligned in the transverse direction 151 is the same as the pitch at which the second strike plates 293 are aligned in the transverse direction 151. In this way, in the example shown in FIG. 12, the second lock 290 is provided in the window unit 205.

In the example shown in FIG. 12, the interior window 210 may be moved in the transverse direction 151. During this move, the first main body 282 and the first strike plate 283 can be aligned with respect to the transverse direction 151. With this alignment, the first main body 282 and the first strike plate 283 engage with each other, and the fixing function of the first latches 281 is exhibited. In this way, the interior window 210 is fixed.

The locking function of the first latches 281 is for temporarily fixing the interior window 210 to the first groove 271. After this temporary fixing is carried out, applying a force in the transverse direction 151 to the interior window 210 will release the temporary fixing and to cause further move of the interior window 210. In this way, in the present embodiment, the temporary fixing by the first latches 281 and the release are repeated. In this way, the first lock 280 stepwise fixes the interior window 210 in a plurality of positions that differ from each other with respect to the transverse direction 151.

The exterior window 220 may be moved in the transverse direction 151. During this move, the second main body 292 and the second strike plate 293 can be aligned with respect to the transverse direction 151. With this alignment, the second main body 292 and the second strike plate 293 engage with each other, and the fixing function of the second latch 291 is exhibited. In this way, the exterior window 220 is fixed.

The locking function of the second latches 291 is for temporarily fixing the exterior window 220 to the third groove 275. After this temporary fixing is carried out, applying a force in the transverse direction to the exterior window 220 will release the temporary fixing and to cause further move of the exterior window 220. In this way, in the present embodiment, the temporary fixing by the second latches 291 and the release are repeated. In this way, the second lock 290 stepwise fixes the exterior window 220 in a plurality of positions that differ from each other with respect to the transverse direction 151.

### (Techniques applicable to Embodiment 1 and Embodiment 2)

Various techniques can be applied to Embodiment 1 and Embodiment 2.

In Embodiment 1, the display 150 may be omitted.

In Embodiment 1, the control device 140 may be omitted. In that case, for example, a human being can manually adjust the relative positions of the interior window 110 and the exterior window 120 while observing the display 150 so that the generated electric power substantially reaches the peak value Py.

A mechanical lock 207 of Embodiment 2 may be combined with the photovoltaic power generation system 100 of Embodiment 1.

That is, the photovoltaic power generation system may include at least one selected from the group consisting of (a) to (c):
(a) a control device 140 capable of controlling the relative move such that at least one selected from the group consisting of electric power generated by the first photoelectric conversion bodies, electric energy generated by the first photoelectric conversion bodies, and the conversion body overlapping area is changed;
(b) a mechanical lock 207 capable of fixing the relative position of the exterior window with respect to the interior window; and
(c) a display 150 capable of displaying visualization information in response to power generation by the first photoelectric conversion bodies.

Specifically, the photovoltaic power generation system may include at least one selected from the group consisting of (A) to (C):
(A) a control device 140 capable of controlling a relative move such that the electric power generated by the first photoelectric conversion bodies approaches a peak value (specifically, becomes a peak value), such that the electric energy generated by the first photoelectric conversion bodies approaches a peak value (specifically, becomes a peak value) and/or, such that the conversion body overlapping area approaches a bottom value (specifically, becomes a bottom value);
(B) a mechanical lock 207 capable of fixing a relative position of the exterior window with respect to the interior window such that the conversion body overlapping area deviates from a peak value (specifically, becomes a bottom value), and
(C) a display 150 capable of displaying visualization information in response to the power generation by the first photoelectric conversion bodies

In Embodiment 1 and Embodiment 2, a window unit including the interior window, the exterior window, and a window frame, is configured.

The above explanation relates to Embodiment 1 and Embodiment 2. In each embodiment, the window unit is explained as an example of a horizontally-sliding window, but it may also be configured as a vertically-sliding window (a sash window). For example, the window unit may also be configured as a single-sliding window. In the case of a single-sliding window, one of the interior window and the exterior window is fixed, while the other is movable. Even in the case of a single-sliding window, it is possible to achieve the relative move of the exterior window in the transverse direction 151 with respect to the interior window.

The number of windows in a window unit is not limited to 2, and it may be 3 or more. The number of glass panes included in double glazing of the interior window and the exterior window is not limited to 2, and it may be 3 or more.

### (Addendum)

The following technique is disclosed by the present disclosure.

### (Technique 1)

A photovoltaic power generation system including a first structure and a second structure, wherein
the first structure includes a plurality of first photoelectric conversion bodies aligned in a first direction at a first spacing and each extending in a second direction as a length direction of the first photoelectric conversion body, the second direction being orthogonal to the first direction, and
the second structure includes a plurality of second photoelectric conversion bodies aligned in the first direction at a second spacing and each extending in the second direction as a length direction of the second photoelectric conversion body,
the photovoltaic power generation system satisfying at least one of the following requirements:
   (1) a first requirement that a dimension of each of the first photoelectric conversion bodies in the first direction is different from a dimension of each of the second photoelectric conversion bodies in the first direction, and
   (2) a second requirement that the first spacing between the first photoelectric conversion bodies is different from the second spacing between the second photoelectric conversion bodies.

Technique 1 is suitable for securing electric power generated by a photovoltaic power generation system.

### (Technique 2)

The photovoltaic power generation system according to Technique 1, wherein
the second structure is disposed closer to a sunlight incident side than the first structure.

### (Technique 3)

The photovoltaic power generation system according to Technique 1 or 2, wherein
the first structure is disposed on an interior side, and
the second structure is disposed on an exterior side.

### (Technique 4)

The photovoltaic power generation system according to any one of Techniques 1 to 3, wherein
the first structure and the second structure are disposed at different positions with respect to a third direction that is orthogonal to both the first direction and the second direction.

### (Technique 5)

The photovoltaic power generation system according to any one of Techniques 1 to 4, satisfying the first requirement.

### (Technique 6)

The photovoltaic power generation system according to Technique 5, wherein
a dimension of each of the first photoelectric conversion bodies in the first direction is larger than a dimension of each of the second photoelectric conversion bodies in the first direction.

### (Technique 7)

The photovoltaic power generation system according to Technique 5, wherein
a dimension of each of the second photoelectric conversion bodies in the first direction is larger than a dimension of the first photoelectric conversion bodies in the first direction.

### (Technique 8)

The photovoltaic power generation system according to any one of Techniques 1 to 7, satisfying the second requirement.

### (Technique 9)

The photovoltaic power generation system according to Technique 8, wherein
the first spacing between the first photoelectric conversion bodies is larger than the second spacing between the second photoelectric conversion bodies.

### (Technique 10)

The photovoltaic power generation system according to Technique 8, wherein
the second spacing between the second photoelectric conversion bodies is larger than the first spacing between the first photoelectric conversion bodies.

### (Technique 11)

The photovoltaic power generation system according to any one of Techniques 1 to 10, satisfying both the first requirement and the second requirement.

### (Technique 12)

The photovoltaic power generation system according to any one of Techniques 1 to 11, wherein
assuming that
   a third direction is a direction that is orthogonal to both the first direction and the second direction, and
   a specific light transmittance is an average value of light transmittance in a wavelength range of 400 nm or more and 800 nm or less,
the specific light transmittance of the first photoelectric conversion body in the third direction is higher than the specific light transmittance of the second photoelectric conversion body in the third direction.

### (Technique 13)

The photovoltaic power generation system according to any one of Techniques 1 to 12, wherein
a light transmissive region extending in the second direction as a length direction of the light transmissive region is provided in each of the second spacings,
the second photoelectric conversion bodies each are aligned in the first direction via the light transmissive region, and
assuming that
   a third direction is a direction that is orthogonal to both the first direction and the second direction, and,
   a specific light transmittance is an average value of light transmittance in a wavelength range of 400 nm or more and 800 nm or less,
the specific light transmittance of the specific light transmissive region in the third direction is higher than the specific light transmittance of the second photoelectric conversion bodies in the third direction.

### (Technique 14)

The photovoltaic power generation system according to Technique 13, wherein
the dimension of the second photoelectric conversion bodies in the first direction is 40% or more and 120% or less of the dimension of the light transmissive region in the first direction.

### (Technique 15)

The photovoltaic power generation system according to Technique 13 or 14, wherein
the light transmissive region is an object having light transmissivity.

### (Technique 16)

The photovoltaic power generation system according to any one of Techniques 1 to 15, wherein
the first photoelectric conversion bodies include a perovskite compound, and
the second photoelectric conversion bodies include a perovskite compound.

### (Technique 17)

The photovoltaic power generation system according to any one of Techniques 1 to 16, including a guide, wherein
the guide allows at least one of the first structure and the second structure to move in the first direction, while engaging with at least one of the first structure and the second structure.

### (Technique 18)

The photovoltaic power generation system according to any one of Techniques 1 to 17, including a stopper, wherein
when a move of the second structure relative to the first structure in the first direction is defined as a relative move, the stopper restricts a relative position of the second structure with respect to the first structure to a first range, the relative position being achieved by the relative move.

The configurations of Techniques 2 to 18 are configuration examples.

### (Technique 19)

The photovoltaic power generation system according to any one of Techniques 1 to 18, wherein
assuming that
   a third direction is a direction that is orthogonal to both the first direction and the second direction,
   a conversion body overlapping area is an overlapping area where the first photoelectric conversion bodies and the second photoelectric conversion bodies overlap one another when viewed from the third direction, and
   a relative move is a move of the second structure relative to the first structure in the first direction,
the relative move achieves alternately a state in which the conversion body overlapping area is at a peak value and a state in which the conversion body overlapping area is at a bottom value, and
the photovoltaic power generation system further includes at least one selected from the group consisting of (a) to (c):
   (a) a control device capable of controlling the relative move such that at least one selected from the group consisting of electric power generated by the first photoelectric conversion bodies, electric energy generated by the first photoelectric conversion bodies, and the conversion body overlapping area is changed;
   (b) a mechanical lock capable of fixing the relative position of the second structure with respect to the first structure; and
   (c) a display capable of displaying visualization information in response to power generation of the first photoelectric conversion bodies.

Technique 19 is suitable for achieving both power generation and an aesthetic appearance.

### (Technique 20)

The photovoltaic power generation system according to Technique 19, wherein
assuming that
   a first total area is a sum of areas of the first photoelectric conversion bodies when viewed from the third direction,
   a second total area is a sum of areas of the second photoelectric conversion bodies when viewed from the third direction,
   a reference area is a sum of the first total area and the second total area;
   an effective area is an area obtained by subtracting the conversion body overlapping area from the reference area, and
   an effective rate is a ratio of the effective area to the reference area,
a state achieved by the relative move includes a state in which the effective rate is 80% or more and 100% or less.

### (Technique 21)

The photovoltaic power generation system according to Technique 19 or 20, including:
the control device; and
a sensor capable of generating a detection value corresponding to the power generation of the first photoelectric conversion bodies, wherein
the control device controls the relative move on the basis of a detection value output from the sensor.

### (Technique 22)

The photovoltaic power generation system according to any one of Techniques 19 to 21, including:
the control device; and
at least one selected from the group consisting of a first position sensor capable of detecting a position of the first structure and a second position sensor capable of detecting a position of the second structure, wherein
the control device controls the relative move on the basis of a detection value detected by the at least one of the first position sensor and the second position sensor.

### (Technique 23)

The photovoltaic power generation system according to any one of Techniques 19 to 22, including:
at least one selected from the group consisting of a first motor capable of moving the first structure and a second motor capable of moving the second structure; and
a power storage device to be supplied with at least one selected from the group consisting of electric power generated by the first photoelectric conversion bodies and electric power generated by the second photoelectric conversion bodies, wherein
at least one of the first motor and the second motor is supplied with electric power from the power storage device.

### (Technique 24)

The photovoltaic power generation system according to any one of Techniques 19 to 23, including the mechanical lock, wherein
the mechanical lock includes at least one selected from the group consisting of a first lock and a second lock,
the first lock fixes stepwise the first structure at a plurality of positions that are different from each other with respect to the first direction, and
the second lock fixes stepwise the second structure at a plurality of positions that are different from each other with respect to the first direction.

### (Technique 25)

The photovoltaic power generation system according to any one of Techniques 19 to 24, including:
a window unit; and
at least one selected from the group consisting of the control device and the mechanical lock, wherein
the window unit includes the first structure, the second structure, and a window frame,
the control device controls the relative move such that the first structure and the second structure overlap at least partially when viewed from the third direction and the electric power generated by the first photoelectric conversion bodies increases, or such that the first structure and the second structure overlap at least partially when viewed from the third direction and the conversion body overlapping area decreases, and
the mechanical lock fixes the relative position such that the first structure and the second structure overlap at least partially when viewed from the third direction and the conversion body overlapping area deviates from the peak value.

The configurations of Techniques 20 to 25 are configuration examples.

### (Technique 26)

A photovoltaic power generation system including a first structure, a second structure, and a guide, wherein
the first structure includes a plurality of first photoelectric conversion bodies aligned in a first direction at a first spacing and each extending in a second direction as a length direction of the first photoelectric conversion body, the second direction being orthogonal to the first direction,
the second structure includes a plurality of second photoelectric conversion bodies aligned in the first direction at a second spacing and each extending in the second direction as a length direction of the second photoelectric conversion body, and
when a move of the second structure relative to the first structure in the first direction is defined as a relative move,
the guide allows the relative move.

Technique 26 is suitable for securing electric power generated by a photovoltaic power generation system. Technique 26 is suitable for achieving both power generation and an aesthetic appearance. Technique 26 can be combined with some or all of Techniques 1 to 25.

### (Technique 27)

A control method for controlling a power generation system, wherein
the power generation system includes a first structure on an interior side and a second structure on an exterior side,
the first structure includes a plurality of first photoelectric conversion bodies aligned in a first direction at a first spacing and each extending in a second direction as a length direction of the first photoelectric conversion body, the second direction being orthogonal to the first direction,
the second structure includes a plurality of second photoelectric conversion bodies aligned in the first direction at a second spacing and each extending in the second direction as a length direction of the second photoelectric conversion body,
a dimension of each of the first photoelectric conversion bodies in the first direction and a dimension of each of the second photoelectric conversion bodies in the first direction are different from each other, and
at least one of electric power generated by the first structure and electric energy generated by the first structure is changed by changing an overlapping area where the first photoelectric conversion bodies and the second photoelectric conversion bodies overlap one another.

According to Technique 27, it is possible to control the power generation by a power generation system.

### (Technique 28)

The control method according to Technique 27, wherein
the overlapping area is changed by changing a relative position between the first structure and the second structure.

According to Technique 28, the overlapping area can be changed.

### (Technique 29)

The control method according to Technique 27 or 28, wherein
the overlapping area is changed such that the generated electric power or the generated electric energy tracks a target value.

According to Technique 29, it is possible to make the generated electric power or the generated electric energy track a target value.

### (Technique 30)

A control method for controlling a power generation system, wherein
the power generation system includes a first structure on an interior side and a second structure on an exterior side,
the first structure includes a plurality of first photoelectric conversion bodies aligned in a first direction at a first spacing and each extending in a second direction as a length direction of the first photoelectric conversion body, the second direction being orthogonal to the first direction,
the second structure includes a plurality of second photoelectric conversion bodies aligned in the first direction at a second spacing and each extending in the second direction as a length direction of the second photoelectric conversion body,
the first spacing between the first photoelectric conversion bodies and the second spacing between the second photoelectric conversion bodies are different from each other, and
at least one of electric power generated by the first structure and electric energy generated by the first structure is changed by changing an overlapping area where the first photoelectric conversion bodies and the second photoelectric conversion bodies overlap one another.

According to Technique 30, it is possible to control the power generation by the power generation system.

### (Technique 31)

The control method according to Technique 30, wherein
the overlapping area is changed by changing a relative position between the first structure and the second structure.

According to Technique 31, the overlapping area can be changed.

### (Technique 32)

The control method according to Technique 30 or 31, wherein
the overlapping area is changed such that the generated electric power or the generated electric energy tracks a target value.

According to Technique 32, it is possible to make the generated electric power or the generated electric energy track a target value.

### INDUSTRIAL APPLICABILITY

The photovoltaic power generation system of the present disclosure can be applied to building components like windows.

## Claims

1. A photovoltaic power generation system comprising a first structure and a second structure, wherein
the first structure comprises a plurality of first photoelectric conversion bodies aligned in a first direction at a first spacing and each extending in a second direction as a length direction of the first photoelectric conversion body, the second direction being orthogonal to the first direction, and
the second structure comprises a plurality of second photoelectric conversion bodies aligned in the first direction at a second spacing and each extending in the second direction as a length direction of the second photoelectric conversion body,
the photovoltaic power generation system satisfying at least one of the following requirements:
(1) a first requirement that a dimension of each of the first photoelectric conversion bodies in the first direction is different from a dimension of each of the second photoelectric conversion bodies in the first direction, and
(2) a second requirement that the first spacing between the first photoelectric conversion bodies is different from the second spacing between the second photoelectric conversion bodies.

2. The photovoltaic power generation system according to claim 1, wherein
the second structure is disposed closer to a sunlight incident side than the first structure.

3. The photovoltaic power generation system according to claim 1, wherein
the first structure is disposed on an interior side, and
the second structure is disposed on an exterior side.

4. The photovoltaic power generation system according to claim 1, wherein
the first structure and the second structure are disposed at different positions with respect to a third direction that is orthogonal to both the first direction and the second direction.

5. The photovoltaic power generation system according to claim 1, satisfying the first requirement.

6. The photovoltaic power generation system according to claim 5, wherein
a dimension of each of the first photoelectric conversion bodies in the first direction is larger than a dimension of each of the second photoelectric conversion bodies in the first direction.

7. The photovoltaic power generation system according to claim 5, wherein
a dimension of each of the second photoelectric conversion bodies in the first direction is larger than a dimension of the first photoelectric conversion bodies in the first direction.

8. The photovoltaic power generation system according to claim 1, satisfying the second requirement.

9. The photovoltaic power generation system according to claim 8, wherein
the first spacing between the first photoelectric conversion bodies is larger than the second spacing between the second photoelectric conversion bodies.

10. The photovoltaic power generation system according to claim 8, wherein
the second spacing between the second photoelectric conversion bodies is larger than the first spacing between the first photoelectric conversion bodies.

11. The photovoltaic power generation system according to claim 1, satisfying both the first requirement and the second requirement.

12. The photovoltaic power generation system according to claim 1, wherein
assuming that
a third direction is a direction that is orthogonal to both the first direction and the second direction, and
a specific light transmittance is an average value of light transmittance in a wavelength range of 400 nm or more and 800 nm or less,
the specific light transmittance of the first photoelectric conversion body in the third direction is higher than the specific light transmittance of the second photoelectric conversion body in the third direction.

13. The photovoltaic power generation system according to claim 1, wherein
a light transmissive region extending in the second direction as a length direction of the light transmissive region is provided in each of the second spacings,
the second photoelectric conversion bodies each are aligned in the first direction via the light transmissive region, and
assuming that
a third direction is a direction that is orthogonal to both the first direction and the second direction, and,
a specific light transmittance is an average value of light transmittance in a wavelength range of 400 nm or more and 800 nm or less,
the specific light transmittance of the specific light transmissive region in the third direction is higher than the specific light transmittance of the second photoelectric conversion bodies in the third direction.

14. The photovoltaic power generation system according to claim 13, wherein
the dimension of the second photoelectric conversion bodies in the first direction is 40% or more and 120% or less of the dimension of the light transmissive region in the first direction.

15. The photovoltaic power generation system according to claim 13, wherein
the light transmissive region is an object having light transmissivity.

16. The photovoltaic power generation system according to claim 1, wherein
the first photoelectric conversion bodies include a perovskite compound, and
the second photoelectric conversion bodies include a perovskite compound.

17. The photovoltaic power generation system according to claim 1, comprising a guide, wherein
the guide allows at least one of the first structure and the second structure to move in the first direction, while engaging with at least one of the first structure and the second structure.

18. The photovoltaic power generation system according to claim 1, comprising a stopper, wherein
when a move of the second structure relative to the first structure in the first direction is defined as a relative move, the stopper restricts a relative position of the second structure with respect to the first structure to a first range, the relative position being achieved by the relative move.

19. The photovoltaic power generation system according to claim 1, wherein
assuming that
a third direction is a direction that is orthogonal to both the first direction and the second direction,
a conversion body overlapping area is an overlapping area where the first photoelectric conversion bodies and the second photoelectric conversion bodies overlap one another when viewed from the third direction, and
a relative move is a move of the second structure relative to the first structure in the first direction,
the relative move achieves alternately a state in which the conversion body overlapping area is at a peak value and a state in which the conversion body overlapping area is at a bottom value, and
the photovoltaic power generation system further comprises at least one selected from the group consisting of (a) to (c):
(a) a control device capable of controlling the relative move such that at least one selected from the group consisting of electric power generated by the first photoelectric conversion bodies, electric energy generated by the first photoelectric conversion bodies, and the conversion body overlapping area is changed;
(b) a mechanical lock capable of fixing the relative position of the second structure with respect to the first structure; and
(c) a display capable of displaying visualization information in response to power generation of the first photoelectric conversion bodies.

20. The photovoltaic power generation system according to claim 19, wherein
assuming that
a first total area is a sum of areas of the first photoelectric conversion bodies when viewed from the third direction,
a second total area is a sum of areas of the second photoelectric conversion bodies when viewed from the third direction,
a reference area is a sum of the first total area and the second total area;
an effective area is an area obtained by subtracting the conversion body overlapping area from the reference area, and
an effective rate is a ratio of the effective area to the reference area,
a state achieved by the relative move includes a state in which the effective rate is 80% or more and 100% or less.

21. The photovoltaic power generation system according to claim 19, comprising:
the control device; and
a sensor capable of generating a detection value corresponding to the power generation of the first photoelectric conversion bodies, wherein
the control device controls the relative move on the basis of a detection value output from the sensor.

22. The photovoltaic power generation system according to claim 19, comprising:
the control device; and
at least one selected from the group consisting of a first position sensor capable of detecting a position of the first structure and a second position sensor capable of detecting a position of the second structure, wherein
the control device controls the relative move on the basis of a detection value detected by the at least one of the first position sensor and the second position sensor.

23. The photovoltaic power generation system according to claim 19, comprising:
at least one selected from the group consisting of a first motor capable of moving the first structure and a second motor capable of moving the second structure; and
a power storage device to be supplied with at least one selected from the group consisting of electric power generated by the first photoelectric conversion bodies and electric power generated by the second photoelectric conversion bodies, wherein
at least one of the first motor and the second motor is supplied with electric power from the power storage device.

24. The photovoltaic power generation system according to claim 19, comprising the mechanical lock, wherein
the mechanical lock comprises at least one selected from the group consisting of a first lock and a second lock,
the first lock fixes stepwise the first structure at a plurality of positions that are different from each other with respect to the first direction, and
the second lock fixes stepwise the second structure at a plurality of positions that are different from each other with respect to the first direction.

25. The photovoltaic power generation system according to claim 19, comprising:
a window unit; and
at least one selected from the group consisting of the control device and the mechanical lock, wherein
the window unit comprises the first structure, the second structure, and a window frame,
the control device controls the relative move such that the first structure and the second structure overlap at least partially when viewed from the third direction and the electric power generated by the first photoelectric conversion bodies increases, or such that the first structure and the second structure overlap at least partially when viewed from the third direction and the conversion body overlapping area decreases, and
the mechanical lock fixes the relative position such that the first structure and the second structure overlap at least partially when viewed from the third direction and the conversion body overlapping area deviates from the peak value.

26. A photovoltaic power generation system comprising a first structure, a second structure, and a guide, wherein
the first structure comprises a plurality of first photoelectric conversion bodies aligned in a first direction at a first spacing and each extending in a second direction as a length direction of the first photoelectric conversion body, the second direction being orthogonal to the first direction,
the second structure comprises a plurality of second photoelectric conversion bodies aligned in the first direction at a second spacing and each extending in the second direction as a length direction of the second photoelectric conversion body, and
when a move of the second structure relative to the first structure in the first direction is defined as a relative move,
the guide allows the relative move.

27. A control method for controlling a power generation system, wherein
the power generation system comprises a first structure on an interior side and a second structure on an exterior side,
the first structure comprises a plurality of first photoelectric conversion bodies aligned in a first direction at a first spacing and each extending in a second direction as a length direction of the first photoelectric conversion body, the second direction being orthogonal to the first direction,
the second structure comprises a plurality of second photoelectric conversion bodies aligned in the first direction at a second spacing and each extending in the second direction as a length direction of the second photoelectric conversion body,
a dimension of each of the first photoelectric conversion bodies in the first direction and a dimension of each of the second photoelectric conversion bodies in the first direction are different from each other, and
at least one of electric power generated by the first structure and electric energy generated by the first structure is changed by changing an overlapping area where the first photoelectric conversion bodies and the second photoelectric conversion bodies overlap one another.

28. The control method according to claim 27, wherein
the overlapping area is changed by changing a relative position between the first structure and the second structure.

29. The control method according to claim 27, wherein
the overlapping area is changed such that the generated electric power or the generated electric energy tracks a target value.

30. A control method for controlling a power generation system, wherein
the power generation system comprises a first structure on an interior side and a second structure on an exterior side,
the first structure comprises a plurality of first photoelectric conversion bodies aligned in a first direction at a first spacing and each extending in a second direction as a length direction of the first photoelectric conversion body, the second direction being orthogonal to the first direction,
the second structure comprises a plurality of second photoelectric conversion bodies aligned in the first direction at a second spacing and each extending in the second direction as a length direction of the second photoelectric conversion body,
the first spacing between the first photoelectric conversion bodies and the second spacing between the second photoelectric conversion bodies are different from each other, and
at least one of electric power generated by the first structure and electric energy generated by the first structure is changed by changing an overlapping area where the first photoelectric conversion bodies and the second photoelectric conversion bodies overlap one another.

31. The control method according to claim 30, wherein
the overlapping area is changed by changing a relative position between the first structure and the second structure.

32. The control method according to claim 30, wherein
the overlapping area is changed such that the generated electric power or the generated electric energy tracks a target value.
